# EUROPEAN PATENT SPECIFICATION

(11) **EP 4 365 671 B1**
(45) Date of publication and mention of the grant of the patent: **16.07.2025**
(21) Application number: 23199417.9
(22) Date of filing: 25.09.2023
(51) Int. Cl.: H10K 59/131, H10K 59/18, G06F 3/14, G09F 9/302, H01R 12/70, G02F 1/1333, H01L 25/075, H10H 20/857

(54) **DISPLAY DEVICE, METHOD OF MANUFACTURING THE SAME AND TILED DISPLAY DEVICE**
ANZEIGEVORRICHTUNG, VERFAHREN ZUR HERSTELLUNG DAVON UND GEKACHELTE ANZEIGEVORRICHTUNG
DISPOSITIF D'AFFICHAGE, SON PROCÉDÉ DE FABRICATION ET DISPOSITIF D'AFFICHAGE EN MOSAÏQUE

(30) Priority: 03.11.2022 KR 20220145212
(43) Date of publication of application: 08.05.2024
(73) Proprietor: Samsung Display Co., Ltd., Yongin-si, Gyeonggi-do 17113 (KR)
(72) Inventor: CHOI, Se Hun, 17113 Yongin-si (KR); LEE, Dong Sung, 17113 Yongin-si (KR); KIM, Byung Hoon, 17113 Yongin-si (KR); KIM, Tae Oh, 17113 Yongin-si (KR)
(74) Representative: Walaski, Jan Filip

(56) References cited:
- US-A1- 2022 328 724

## Description

### BACKGROUND

### 1. Field

The present disclosure relates to a display device, a method of manufacturing the same, and a tiled display device including the same.

### 2. Description of the Related Art

With the advance of information-oriented society, more and more demands are placed on display devices for displaying images in various ways. For example, display devices are employed in various electronic devices such as smartphones, digital cameras, laptop computers, navigation devices, and smart televisions. The display device may be a flat panel display device such as a liquid crystal display device, a field emission display device and an organic light emitting display device. Among the flat panel display devices, in the light emitting display device, because each of the pixels of a display panel includes a light emitting element capable of emitting light by itself, an image can be displayed without a backlight unit providing light to the display panel. US 2022/328724 A discloses a pad section of a display device. The pad section comprising a first plurality of pads PD and first and second barrier insulating layers BIL1 and BIL2 and the pad being disposed in a hole of BIL1.

When the display device is manufactured in a large size, a defect rate of the light emitting element may increase due to an increase in the number of pixels, thereby deteriorating productivity and/or reliability of the display device. To solve this problem, in a tiled display device, a large-sized screen may be implemented by connecting a plurality of display devices having a relatively small size. The tiled display device may include a boundary portion called a seam between the plurality of display devices, due to a non-display area or a bezel area of each of the plurality of display devices adjacent to each other. When a single image is displayed on the entire screen, the boundary portion between the plurality of display devices gives a sense of disconnection over the entire screen, thereby reducing a sense of immersion in the image.

### SUMMARY

Aspects and features of embodiments of the present disclosure provide a display device capable of preventing damage to an upper substrate or a display layer in an etching process of a lower substrate, a method of manufacturing the same, and a tiled display device including the same.

Aspects and features of embodiments of the present disclosure also provide a display device capable of removing a sense of disconnection between a plurality of display devices and improving a sense of immersion in an image by preventing a boundary portion or a non-display area between the plurality of display devices from being recognized, a method of manufacturing the same, and a tiled display device including the same.

However, aspects and features of embodiments of the present disclosure are not restricted to those set forth herein. The above and other aspects of the present disclosure will become more apparent to one of ordinary skill in the art to which the present disclosure pertains by referencing the detailed description of the present disclosure given below.

According to one or more embodiments of the present disclosure, a display device includes a substrate including an opening hole, a first barrier insulating layer on the substrate, a plurality of first pad portions on the first barrier insulating layer and in a first contact hole partially penetrating the first barrier insulating layer, a second barrier insulating layer on the first barrier insulating layer and the plurality of first pad portions, a plurality of second pad portions on the second barrier insulating layer and in a second contact hole partially penetrating the first barrier insulating layer and the second barrier insulating layer, a third barrier insulating layer on the second barrier insulating layer and the plurality of second pad portions, a display layer on the third barrier insulating layer, and a flexible film under the substrate, and inserted into the opening hole to be electrically connected to the plurality of first and second pad portions, wherein each of the plurality of first pad portions and the plurality of second pad portions includes a main body portion inserted into the first contact hole or the second contact hole, and an extension portion at both sides of the main body portion.

The extension portion of a first pad portion of the plurality of first pad portions may overlap the extension portion of a second pad portion of the plurality of second pad portions in a thickness direction of the substrate.

The plurality of first pad portions and the plurality of second pad portions may be spaced from each other.

The extension portion of a first pad portion from among the plurality of first pad portions may be spaced from the second contact hole and the main body portion of a second pad portion from among the plurality of second pad portions.

A first pad portion from among the plurality of first pad portions and a second pad portion from among the plurality of second pad portions may have lower ends of the main body portions spaced from each other, respectively, and a gap between the lower end of the first pad portion and the lower end of the second pad portion may be greater than a width of the extension portion of each of the first pad portion and the second pad portion.

A width of the extension portion of each of the first pad portion and the second pad portion may be in a range of a one half width to a full width of the gap between the lower end of the first pad portion and the lower end of the second pad portion.

The gap between the lower end of the first pad portion and the lower end of the second pad portion is about 16 µm, and the width of the extension portion of each of the first pad portion and the second pad portion is in a range of 8 µm to 16 µm.

The display device may further include a plurality of first dummy pad portions spaced from a first pad portion from among the plurality of first pad portions and a second pad portion from among the plurality of second pad portions, the plurality of first dummy pad portions being on the first barrier insulating layer or the second barrier insulating layer without being electrically connected to the flexible film.

Each of the plurality of first dummy pad portions may overlap the opening hole.

The display device may further include a plurality of second dummy pad portions spaced from the plurality of first dummy pad portions, the plurality of second dummy pad portions being on the first barrier insulating layer or the second barrier insulating layer without overlapping the opening hole.

The display device may further include a second substrate between the third barrier insulating layer and the display layer; and a fourth barrier insulating layer between the second substrate and the display layer, wherein the display layer may include a connection portion on the fourth barrier insulating layer and electrically connected to a first pad portion from among the plurality of first pad portions or a second pad portion from among the plurality of second pad portions, a data line on the fourth barrier insulating layer and extending in a first direction, and a high potential line on the fourth barrier insulating layer and extending in the first direction.

The first pad portion and the second pad portion are configured to supply a data voltage to a plurality of data lines through the connection portion, and the first pad portion and the second pad portion are configured to supply a high potential voltage to the plurality of high potential lines through the connection portion.

The display layer may further include a buffer layer on the connection portion, a thin film transistor including an active layer on the buffer layer, and a connection electrode on the active layer, wherein one end of the connection electrode may be connected to the high potential line, and the other end of the connection electrode may be connected to the thin film transistor.

The display layer may further include a light emitting element layer on the connection electrode, and the light emitting element layer may include a first electrode connected to the connection electrode, a second electrode on the same layer as the first electrode, and a light emitting element on the first electrode and the second electrode and electrically connected to the first electrode and the second electrode.

According to one or more embodiments of the present disclosure, a method of manufacturing a display device, includes preparing a first substrate, forming a first barrier insulating layer on the first substrate and forming a plurality of first contact holes penetrating the first barrier insulating layer, forming first pad portions on the first barrier insulating layer and partially inserted into the first contact hole, forming a second barrier insulating layer on the first barrier insulating layer and the first pad portions, and forming a plurality of second contact holes penetrating the first barrier insulating layer and the second barrier insulating layer, forming second pad portions on the second barrier insulating layer and partially inserted into the second contact hole, forming a third barrier insulating layer on the second barrier insulating layer and the second pad portions, forming a display layer on the third barrier insulating layer, etching the first substrate to form an opening hole to partially expose the first pad portions, the second pad portions, and the first barrier insulating layer, and inserting a flexible film into the opening hole to be electrically connected to each of the first pad portions and the second pad portions.

Each of the first pad portions and the second pad portions may include a main body portion inserted into the first contact hole or the second contact hole, and an extension portion at both sides of the main body portion, and the extension portion of a first pad portion of the first pad portions may overlap the extension portion of a second pad portion of the second pad portions in a thickness direction of the first substrate.

The partially exposing of the first pad portions, the second pad portions, and the first barrier insulating layer may comprise irradiating the first substrate with laser having a wavelength of 300 nm to 400 nm.

The method may further comprise forming a second substrate on the third barrier insulating layer and forming a fourth barrier insulating layer on the second substrate.

The first pad portion and the second pad portion may have lower ends of the main body portions spaced from each other, respectively, and a gap between the lower end of the first pad portion and the lower end of the second pad portion may be greater than a width of the extension portion of each of the first pad portion and the second pad portion.

A width of the extension portion of each of the first pad portions and the second pad portions may be in a range of a one half width to a full width of the gap between the lower end of the first pad portion and the lower end of the second pad portion.

According to one or more embodiments of the present disclosure, a tiled display device includes a plurality of display devices, each of the plurality of display devices including a display area having a plurality of pixels and a non-display area around the display area, and a bonding member configured to bond the plurality of display devices, wherein at least one of the plurality of display devices includes, a substrate including an opening hole, a first barrier insulating layer on the substrate, a plurality of first pad portions on the first barrier insulating layer and in a first contact hole partially penetrating the first barrier insulating layer, a second barrier insulating layer on the first barrier insulating layer and the plurality of first pad portions, a plurality of second pad portions on the second barrier insulating layer and in a second contact hole partially penetrating the first barrier insulating layer and the second barrier insulating layer, a third barrier insulating layer on the second barrier insulating layer and the plurality of second pad portions, a display layer on the third barrier insulating layer, and a flexible film under the substrate, and inserted into the opening hole and electrically connected to the pad portion, wherein each of the plurality of first pad portions and the plurality of second pad portions includes a main body portion inserted into the first contact hole or the second contact hole, and an extension portion at both sides of the main body portion.

The extension portion of a first pad portion of the plurality of first pad portions may overlap the extension portion of a second pad portion of the plurality of second pad portions in a thickness direction of the substrate.

In the display device according to one or more embodiments, a plurality of pad portions may be dividedly disposed on different barrier insulating layers and may be disposed to overlap each other in a thickness direction. Accordingly, it is possible to prevent the laser from reaching the upper substrate when the laser is irradiated from the bottom surface of the lower substrate in the manufacturing process of the display device. In the display device, the disposition of the pad portions may be designed such that the laser is absorbed by the pad portion in the laser process of etching the lower substrate, and the upper substrate may be prevented from being lifted or the upper substrate and the display layer may be prevented from being damaged.

However, effects according to the embodiments of the disclosure are not limited to those exemplified above and various other effects are incorporated herein.

### BRIEF DESCRIPTION OF THE DRAWINGS

The above and other aspects and features of the present disclosure will become more apparent by describing in detail embodiments thereof with reference to the attached drawings, in which:
FIG. 1 is a plan view illustrating a tiled display device;
FIG. 2 is a cross-sectional view taken along the line I-I' of FIG. 1;
FIG. 3 is an enlarged view of an area A1 of FIG. 2;
FIG. 4 is a bottom view illustrating a display device;
FIG. 5 is an enlarged bottom view illustrating a part of a display device;
FIG. 6 is a plan view illustrating a disposition of pad portions disposed on a bottom surface of a display device;
FIG. 7 is a cross-sectional view taken along the line VII-VII' of FIG. 6;
FIG. 8 is an enlarged view illustrating the disposition of the pad portions of FIG. 7;
FIG. 9 is a plan view illustrating a relative disposition of first pad portions and second pad portions of a display device;
FIG. 10 is a view illustrating a pad portion, a fan-out line, a sensing line, and a data line in a display device;
FIG. 11 is a view illustrating a pad portion, a power connection line, a high potential line, and a horizontal voltage line in a display device;
FIG. 12 is a view illustrating a pad portion, a power connection line, a low potential line, and a vertical voltage line in a display device;
FIG. 13 is a view illustrating a pad portion, a fan-out line, and a gate line in the display device;
FIG. 14 is a block diagram illustrating pixels and lines in a display device;
FIG. 15 is a circuit diagram illustrating the pixel of FIG. 14;
FIG. 16 is a cross-sectional view taken along the line II-II' of FIG. 1;
FIGS. 17 to 29 are cross-sectional views illustrating a manufacturing process of a display device;
FIG. 30 is a plan view illustrating a disposition of pad portions disposed on a bottom surface of a display device;
FIG. 31 is a cross-sectional view taken along the line B1-B1' in FIG. 30;
FIG. 32 is a plan view illustrating a disposition of pad portions disposed on a bottom surface of a display device; and
FIG. 33 is a cross-sectional view taken along the line B2-B2' of FIG. 32.

### DETAILED DESCRIPTION

Embodiments of the present disclosure will now be described more fully hereinafter with reference to the accompanying drawings, in which embodiments of the present disclosure are shown. The present disclosure may, however, be embodied in different forms and should not be construed as limited to the embodiments set forth herein. Rather, these embodiments are provided so that the present disclosure will be thorough and complete, and will fully convey the scope of the present disclosure to those skilled in the art.

It will also be understood that when a layer is referred to as being "on" another layer or substrate, it can be directly on the other layer or substrate, or intervening layers may also be present. The same reference numbers indicate the same components throughout the specification.

It will be understood that, although the terms "first," "second," etc. may be used herein to describe various elements, these elements should not be limited by these terms. These terms are only used to distinguish one element from another element. For instance, a first element discussed below could be termed a second element without departing from the teachings and scope of the present disclosure. Similarly, the second element could also be termed the first element.

Hereinafter, embodiments will be described with reference to the accompanying drawings.

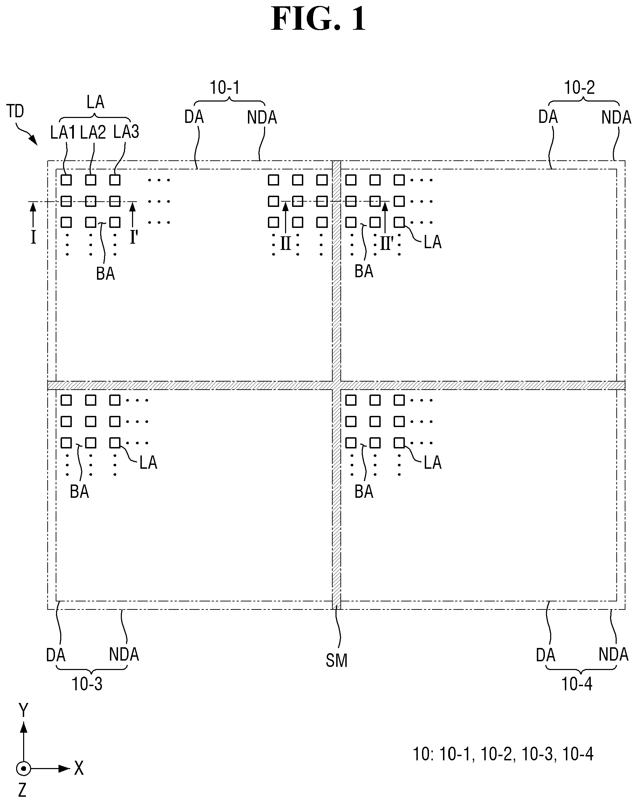

FIG. 1 is a plan view illustrating a tiled display device.

Referring to FIG. 1, a tiled display device TD may include a plurality of display devices 10. The plurality of display devices 10 may be arranged in a grid form, but are not limited thereto. The plurality of display devices 10 may be connected in the first direction (X-axis direction) or the second direction (Y-axis direction), and the tiled display device TD may have a particular shape. For example, the plurality of display devices 10 may have the same size, but are not limited thereto. For another example, the plurality of display devices 10 may have different sizes.

The tiled display device TD may include first to fourth display devices 10-1 to 10-4. The number and connection relationship of the display devices 10 are not limited to that shown in FIG. 1. The number of the display devices 10 may be determined according to the size of each of the display devices 10 and the tiled display device TD.

Each of the plurality of display devices 10 may have a rectangular shape including long sides and short sides. The plurality of display devices 10 may be arranged such that the long sides or the short sides thereof are connected to each other. Some of the display devices 10 may be disposed at the edge of the tiled display device TD to form one side of the tiled display device TD. Some others of the display devices 10 may be disposed at corners of the tiled display device TD to form two adjacent sides of the tiled display device TD. Yet some others of the display devices 10 may be disposed on the inner side of the tiled display device TD, and may be surrounded by other display devices 10.

Each of the plurality of display devices 10 may include a display area DA and a non-display area NDA. The display area DA may include a plurality of pixels to display an image. Each of the pixels may include an organic light emitting diode (OLED) having an organic light emitting layer, a quantum dot light emitting diode (LED) including a quantum dot light emitting layer, a micro LED, or an inorganic LED having an inorganic semiconductor. In the following, the case where each of the plurality of pixels includes an inorganic light emitting diode will be mainly described, but the present disclosure is not limited thereto. The non-display area NDA may be disposed around the display area DA to surround the display area DA, and may not display an image.

The display device 10 may include a plurality of pixels arranged along a plurality of rows and columns in the display area DA. Each of the plurality of pixels may include an emission area LA defined by a pixel defining layer or bank, and may emit light having a suitable peak wavelength (e.g., a predetermined peak wavelength) through the emission area LA. For example, the display area DA of the display device 10 may include first to third emission areas LA1, LA2, and LA3. Each of the first to third emission areas LA1, LA2, and LA3 may be an area in which light generated from a light emitting element of the display device 10 is emitted to the outside of the display device 10.

The first to third emission areas LA1, LA2, and LA3 may emit light having a suitable peak wavelength (e.g., a predetermined peak wavelength) to the outside of the display device 10. The first emission area LA1 may emit light of a first color, the second emission area LA2 may emit light of a second color, and the third emission area LA3 may emit light of a third color. For example, the first color light may be red light having a peak wavelength in the range from about 610 nm to 650 nm, the second color light may be green light having a peak wavelength in the range from about 510 nm to 550 nm, and the third color light may be blue light having a peak wavelength in the range from about 440 nm to 480 nm, but the present disclosure is not limited thereto.

The first to third emission areas LA1, LA2, and LA3 may be sequentially arranged repetitively along the first direction (X-axis direction) in the display area DA. For example, the size of the third emission area LA3 may be larger than that of the first emission area LA1, and the size of the first emission area LA1 may be larger than that of the second emission area LA2. However, the present disclosure is not limited thereto. For another example, the first emission area LA1, the second emission area LA2, and the third emission area LA3 may be substantially the same in size.

The display area DA of the display device 10 may include a light blocking area BA surrounding the plurality of emission areas LA. The light blocking area BA may prevent the colored lights emitted from the first to third emission areas LA1, LA2, and LA3 from mixing with one another.

The tiled display device TD may have a planar shape as a whole, but is not limited thereto. The tiled display device TD may have a three-dimensional shape to provide a three-dimensional effect to a user. For example, when the tiled display device TD has a three-dimensional shape, at least some of the plurality of display devices 10 may have a curved shape. For another example, the plurality of display devices 10 may each have a planar shape and may be connected to each other at a suitable angle (e.g., a predetermined angle), so that the tiled display device TD may have a three-dimensional shape.

The tiled display device TD may include a coupling area SM disposed between a plurality of display areas DA. The tiled display device TD may be formed by connecting non-display areas NDA of the adjacent display devices 10. The plurality of display devices 10 may be connected to each other through a bonding member or an adhesive member disposed in the coupling area SM. The coupling area SM may not include a pad portion or a flexible film attached to the pad portion. Accordingly, the distance between the display areas DA of the plurality of display devices 10 may be small enough that the coupling area SM is not recognized by the user. Further, the reflectance of external light of the display areas DA of the plurality of display devices 10 may be substantially the same as that of the coupling area SM. Accordingly, in the tiled display device TD, the coupling area SM between the plurality of display devices 10 may be prevented from being recognized by the user, thereby reducing a sense of disconnection between the plurality of display devices 10 and improving a sense of immersion in an image.

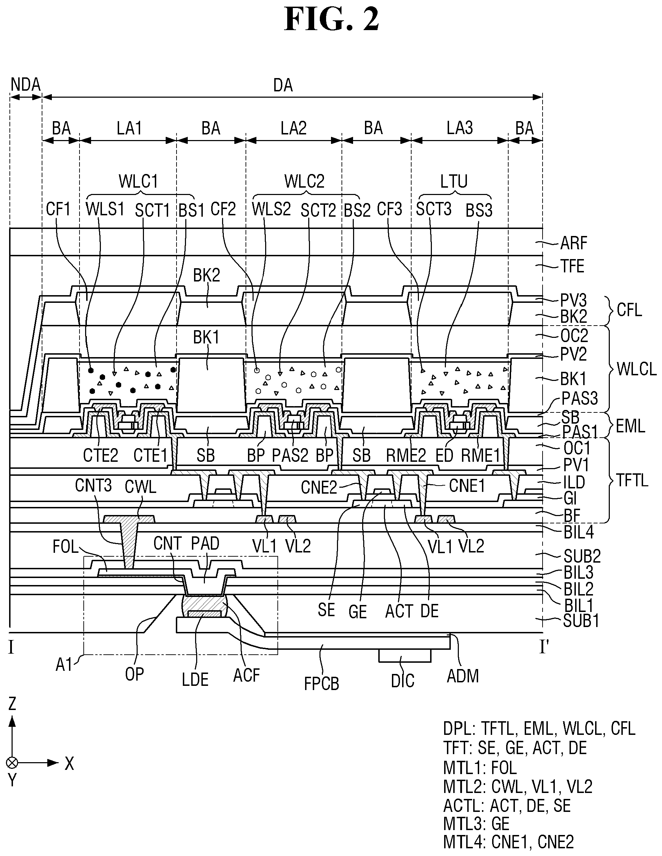

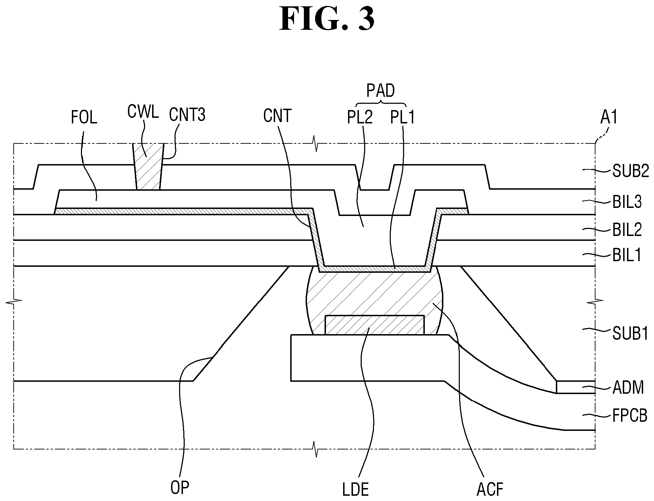

FIG. 2 is a cross-sectional view taken along the line I-I' of FIG. 1. FIG. 3 is an enlarged view of an area A1 of FIG. 2.

Referring to FIGS. 2 and 3, the display area DA of the display device 10 may include first to third emission areas LA1, LA2, and LA3. Each of the first to third emission areas LA1, LA2, and LA3 may be an area in which light generated from the light emitting element ED of the display device 10 is emitted to the outside of the display device 10.

The display device 10 may include a first substrate SUB1, a first barrier insulating layer BIL1, a first metal layer MTL1, a second barrier insulating layer BIL2, a second substrate SUB2, a third barrier insulating layer BIL3, a fourth barrier insulating layer BIL4, a display layer DPL, an encapsulation layer TFE, an anti-reflection film ARF, a flexible film FPCB, and a display driver DIC.

The first substrate SUB1 may support the display device 10. The first substrate SUB1 may be a base substrate or a base member. The first substrate SUB1 may be a flexible substrate that can be bent, folded, and/or rolled. For example, the first substrate SUB1 may include an insulating material such as a polymer resin such as polyimide (PI), but the present disclosure is not limited thereto. As another example, the first substrate SUB1 may be a rigid substrate including a glass material.

The first substrate SUB1 may include an opening hole OP, also referred to as an opening OP. The opening hole OP may be etched from the bottom surface of the first substrate SUB1 to penetrate the top surface of the first substrate SUB1. For example, the lower width of the opening hole OP may be greater than the upper width of the opening hole OP. During the manufacturing process of the display device 10, a pad portion PAD inserted into a contact hole CNT may be exposed through the opening hole OP, and the pad portion PAD may be electrically connected to a lead electrode LDE of the flexible film FPCB through a connection film ACF inserted into the opening hole OP.

The first barrier insulating layer BIL1 may be disposed on the first substrate SUB1. The second barrier insulating layer BIL2 may include an inorganic layer capable of preventing permeation of air or moisture. The second barrier insulating layer BIL2 may include at least one selected from among a silicon nitride layer, a silicon oxynitride layer, a silicon oxide layer, a titanium oxide layer, an aluminum oxide layer, and/or an amorphous silicon layer. For example, the second barrier insulating layer BIL2 may include amorphous silicon (a-Si) having a thickness equal to or less than about 50 Å (5nm) and/or silicon oxide (SiOx) having a thickness equal to or greater than about 3000 Å (300nm), but is not limited thereto.

The second barrier insulating layer BIL2 may be disposed on the first barrier insulating layer BIL1. The second barrier insulating layer BIL2 may include an inorganic layer capable of preventing permeation of air or moisture. The second barrier insulating layer BIL2 may include at least one selected from among a silicon nitride layer, a silicon oxynitride layer, a silicon oxide layer, a titanium oxide layer, an aluminum oxide layer, and/or an amorphous silicon layer. For example, the second barrier insulating layer BIL2 may include amorphous silicon (a-Si) having a thickness equal to or less than about 50 Å (5nm) and/or silicon oxide (SiOx) having a thickness equal to or greater than about 3000 Å (300nm), but is not limited thereto.

The first barrier insulating layer BIL1 and the second barrier insulating layer BIL2 may include the contact hole CNT. The contact hole CNT may be etched from the top surface of the first barrier insulating layer BIL1 and penetrate to the bottom surface of the first barrier insulating layer BIL1, or may be etched from the top surface of the second barrier insulating layer BIL2 and penetrate to the bottom surface of the first barrier insulating layer BIL1. For example, the upper width of the contact hole CNT may be greater than the lower width of the contact hole CNT.

The first metal layer MTL1 may be disposed on the first barrier insulating layer BIL1 or the second barrier insulating layer BIL2. The first metal layer MTL1 may include the fan-out line FOL. For example, the first metal layer MTL1 may have a thickness equal to or greater than about 1500 Å, but is not limited thereto.

The pad portion PAD may be integrally formed with the fan-out line FOL and inserted into the contact hole CNT. The pad portion PAD may electrically connect the flexible film FPCB to a connection portion CWL. The pad portion PAD may be exposed through the opening hole OP of the first substrate SUB1. The pad portion PAD may be electrically connected to the lead electrode LDE of the flexible film FPCB through the connection film ACF. The fan-out line FOL may be electrically connected to a data line, a power line, or a gate line through the connection portion CWL. The data line or the power line may be connected to a drain electrode DE of a thin film transistor TFT. The gate line may be connected to the gate electrode GE of the thin film transistor TFT. Accordingly, the fan-out line FOL may supply a data voltage, a power voltage, and/or a gate signal received from the display driver DIC of the flexible film FPCB to the thin film transistor TFT of the pixel through the connection portion CWL. The display device 10 includes the fan-out line FOL disposed in the display area DA, so that the area of the non-display area NDA may be reduced or minimized.

For example, the pad portion PAD and the first metal layer MTL1 may be formed as a single layer or multiple layers including at least one selected from among of molybdenum (Mo), aluminum (Al), chromium (Cr), gold (Au), silver (Ag), titanium (Ti), nickel (Ni), palladium (Pd), indium (In), neodymium (Nd), and/or copper (Cu). The pad portion PAD and the first metal layer MTL1 may include a lower metal layer PL1 including titanium (Ti) and an upper metal layer PL2 disposed on the lower metal layer PL1 and including copper (Cu). However, the present disclosure is not limited thereto.

The pad portion PAD may absorb the ultraviolet laser in a laser process of forming the opening hole OP in the first substrate SUB1 during the manufacturing process of the display device 10. The laser irradiated to form the opening hole OP may pass through the first barrier insulating layer BIL1, the second barrier insulating layer BIL2, and a third barrier insulating layer BIL3 to be described later, and the second substrate SUB2 disposed thereon may be damaged by the laser. In the display device 10, the damage to the second substrate SUB2 or the display layer DPL by the laser irradiated during the etching process of the first substrate SUB1 for forming the opening hole OP may be prevented through the disposition design of the pad portions PAD capable of absorbing the ultraviolet laser. A description of the disposition of the pad portions PAD will be described later with reference to other drawings.

The third barrier insulating layer BIL3 may be disposed on the second barrier insulating layer BIL2 and the first metal layer MTL1. The third barrier insulating layer BIL3 may include an inorganic layer capable of preventing permeation of air or moisture. The third barrier insulating layer BIL3 may include at least one selected from among of a silicon nitride layer, a silicon oxynitride layer, a silicon oxide layer, a titanium oxide layer, an aluminum oxide layer, and/or an amorphous silicon layer. For example, the third barrier insulating layer BIL3 may include silicon nitride (SiNx) having a thickness equal to or less than about 500 Å (50nm) and/or silicon oxynitride (SiOxNy) having a thickness equal to or greater than about 1500 Å (150nm), but is not limited thereto.

The second substrate SUB2 may be disposed on the third barrier insulating layer BIL3. The second substrate SUB2 may be a base substrate or a base member. The second substrate SUB2 may be a flexible substrate that can be bent, folded and/or rolled. For example, the second substrate SUB2 may include an insulating material such as a polymer resin such as polyimide (PI), but the present disclosure is not limited thereto.

The fourth barrier insulating layer BIL4 may be disposed on the second substrate SUB2. The fourth barrier insulating layer BIL4 may include an inorganic layer capable of preventing permeation of air or moisture. For example, the fourth barrier insulating layer BIL4 may include at least one selected from among of a silicon nitride layer, a silicon oxynitride layer, a silicon oxide layer, a titanium oxide layer, an aluminum oxide layer, and/or an amorphous silicon layer, but the present disclosure is not limited thereto.

The fourth barrier insulating layer BIL4, the second substrate SUB2, and the third barrier insulating layer BIL3 may include a third contact hole CNT3. The third contact hole CNT3 may be etched from the top surface of the fourth barrier insulating layer BIL4 to penetrate the bottom surface of the third barrier insulating layer BIL3. For example, the upper width of the third contact hole CNT3 may be greater than the lower width of the third contact hole CNT3. During the manufacturing process of the display device 10, the top surface of the fan-out line FOL may be exposed through the third contact hole CNT3, and the fan-out line FOL may be in contact with the connection portion CWL inserted into the third contact hole CNT3.

The display layer DPL may be disposed on the fourth barrier insulating layer BIL4. The display layer DPL may include a thin film transistor layer TFTL, a light emitting element layer EML, a wavelength conversion layer WLCL and a color filter layer CFL. The thin film transistor layer TFTL may include a second metal layer MTL2, a buffer layer BF, an active layer ACTL, a gate insulating layer GI, a third metal layer MTL3, an interlayer insulating layer ILD, a fourth metal layer MTL4, a first passivation layer PV1, and a first planarization layer OC1.

The second metal layer MTL2 may be disposed on the fourth barrier insulating layer BIL4. The second metal layer MTL2 may include the connection portion CWL and first and second voltage lines VL1 and VL2. The connection portion CWL and the first and second voltage lines VL1 and VL2 may be formed of the same material in the same layer, but the present disclosure is not limited thereto. For example, the second metal layer MTL2 may be formed as a single layer or multiple layers including at least one selected from among of molybdenum (Mo), aluminum (Al), chromium (Cr), gold (Au), silver (Ag), titanium (Ti), nickel (Ni), palladium (Pd), indium (In), neodymium (Nd), and/or copper (Cu).

The connection portion CWL may be inserted into the third contact hole CNT3 to be connected to the fan-out line FOL. For example, the connection portion CWL may be electrically connected to the data line to supply the data voltage to the thin film transistor TFT. The connection portion CWL may be electrically connected to the power line to supply the power voltage to the thin film transistor TFT. The connection portion CWL may be electrically connected to the gate line to supply the gate signal to the gate electrode GE of the thin film transistor TFT. Accordingly, the connection portion CWL may supply the data voltage, the power voltage, and/or the gate signal received from the display driver DIC through the fan-out line FOL to the thin film transistor TFT of the pixel.

The first and second voltage lines VL1 and VL2 may extend in the second direction (Y-axis direction) in the display area DA. Each of the first and second voltage lines VL1 and VL2 may be electrically connected to the fan-out line FOL. Each of the first and second voltage lines VL1 and VL2 may be electrically connected to the thin film transistor TFT and/or the light emitting element ED. For example, each of the first and second voltage lines VL1 and VL2 may be a data line, a high potential line, a low potential line, or a sensing line, but is not limited thereto.

The buffer layer BF may be disposed on the second metal layer MTL2 and the fourth barrier insulating layer BIL4. The buffer layer BF may include an inorganic material capable of preventing permeation of air or moisture. For example, the buffer layer BF may include a plurality of inorganic layers laminated alternately.

The active layer ACTL may be disposed on the buffer layer BF. The active layer ACTL may include a semiconductor region ACT, a drain electrode DE, and a source electrode SE of the thin film transistor TFT. The semiconductor region ACT may overlap the gate electrode GE in the thickness direction (Z-axis direction), and may be insulated from the gate electrode GE by the gate insulating layer GI. The drain electrode DE and the source electrode SE may be formed by making a material of the semiconductor region ACT conductive. The thin film transistor TFT may constitute a pixel circuit of each of the plurality of pixels. For example, the thin film transistor TFT may be a switching transistor or a driving transistor of the pixel circuit.

The gate insulating layer GI may be disposed on the active layer ACTL and the buffer layer BF. The gate insulating layer GI may insulate the gate electrode GE from the semiconductor region ACT of the thin film transistor TFT. The gate insulating layer GI may include a contact hole through which each of the first and second connection electrodes CNE1 and CNE2 passes.

The third metal layer MTL3 may be disposed on the gate insulating layer GI. The third metal layer MTL3 may include the gate electrode GE of the thin film transistor TFT. The gate electrode GE may overlap the semiconductor region ACT with the gate insulating layer GI interposed therebetween. The gate electrode GE may receive a gate signal from the gate line. For example, the third metal layer MTL3 may be formed as a single layer or multiple layers including at least one selected from among of molybdenum (Mo), aluminum (Al), chromium (Cr), gold (Au), silver (Ag), titanium (Ti), nickel (Ni), palladium (Pd), indium (In), neodymium (Nd), and/or copper (Cu).

The interlayer insulating layer ILD may be disposed on the third metal layer MTL3 and the gate insulating layer GI. The interlayer insulating layer ILD may insulate the third and fourth metal layers MTL3 and MTL4. The interlayer insulating layer ILD may include a contact hole through which each of the first and second connection electrodes CNE1 and CNE2 passes.

The fourth metal layer MTL4 may be disposed on the interlayer insulating layer ILD. The fourth metal layer MTL4 may include the first and second connection electrodes CNE1 and CNE2. The first and second connection electrodes CNE1 and CNE2 may be formed of the same material in the same layer, but the present disclosure is not limited thereto. For example, the fourth metal layer MTL4 may be formed as a single layer or multiple layers including at least one selected from among molybdenum (Mo), aluminum (Al), chromium (Cr), gold (Au), silver (Ag), titanium (Ti), nickel (Ni), palladium (Pd), indium (In), neodymium (Nd), and/or copper (Cu).

The first connection electrode CNE1 may electrically connect the first voltage line VL1 to the drain electrode DE of the thin film transistor TFT. One end of the first connection electrode CNE1 may be in contact with the first voltage line VL1 of the second metal layer MTL2, and the other end of the first connection electrode CNE1 may be in contact with the drain electrode DE of the active layer ACTL.

The second connection electrode CNE2 may electrically connect the source electrode SE of the thin film transistor TFT to a first electrode RME1. One end of the second connection electrode CNE2 may be in contact with the source electrode SE of the active layer ACTL, and the other end of the second connection electrode CNE2 may be in contact with the first electrode RME1 of the light emitting element layer EML.

The first passivation layer PV1 may be disposed on the fourth metal layer MTL4 and the interlayer insulating layer ILD. The first passivation layer PV1 may protect the thin film transistor TFT. The first passivation layer PV1 may include a contact hole through which the first electrode RME1 passes.

The first planarization layer OC1 may be disposed on the first passivation layer PV1 to flatten the upper end of the thin film transistor layer TFTL. For example, the first planarization layer OC1 may include a contact hole through which the first electrode RME1 passes. Here, the contact hole of the first planarization layer OC1 may be connected to the contact hole of the first passivation layer PV1. The first planarization layer OC1 may contain an organic insulating material such as polyimide (PI).

The light emitting element layer EML may be disposed on the thin film transistor layer TFTL. The light emitting element layer EML may include a barrier wall BP, the first electrode RME1, a second electrode RME2, a first insulating layer PAS1, a sub-bank SB, the light emitting element ED, a second insulating layer PAS2, a first contact electrode CTE1, a second contact electrode CTE2, and a third insulating layer PAS3.

The barrier wall BP may be disposed on the first planarization layer OC1. The barrier wall BP may protrude from the top surface of the first planarization layer OC1. A plurality of barrier walls BP may be disposed in an opening area or the emission area LA of each of the plurality of pixels. The plurality of light emitting elements ED may be disposed between the plurality of barrier walls BP. The barrier wall BP may have inclined side surfaces, and the light emitted from the plurality of light emitting elements ED may be reflected by the first and second electrodes RME1 and RME2 arranged on the barrier walls BP. For example, the barrier wall BP may include an organic insulating material such as polyimide (PI).

The first electrode RME1 may be disposed on the first planarization layer OC1 and the barrier wall BP. The first electrode RME1 may be disposed on the barrier wall BP located on one side of the light emitting elements ED. The first electrode RME1 may be disposed on the inclined surfaces of the barrier wall BP and reflect the light emitted from the light emitting element ED. The first electrode RME1 may be inserted into the contact hole formed in the first planarization layer OC1 and the first passivation layer PV1 and connected to the second connection electrode CNE2. The first electrode RME1 may be electrically connected to one end of the light emitting element ED through the first contact electrode CTE1. For example, the first electrode RME1 may receive a voltage that is proportional to the luminance of the light emitting element ED from the thin film transistor TFT of the pixel.

The second electrode RME2 may be disposed on the first planarization layer OC1 and the barrier wall BP. The second electrode RME2 may be disposed on the barrier wall BP located on the other side of the light emitting elements ED. The second electrode RME2 may be disposed on the inclined surfaces of the barrier wall BP and reflect the light emitted from the light emitting element ED. The second electrode RME2 may be electrically connected to the other end of the light emitting element ED through the second contact electrode CTE2. For example, the second electrode RME2 may receive a low potential voltage supplied from a low potential line to all the pixels.

The first and second electrodes RME1 and RME2 may contain a conductive material having high reflectivity. For example, the first and second electrodes RME1 and RME2 may contain at least one selected from among aluminum (Al), silver (Ag), copper (Cu), nickel (Ni), and/or lanthanum (La). For another example, the first and second electrodes RME1 and RME2 may include a material such as indium tin oxide (ITO), indium zinc oxide (IZO), and/or indium tin zinc oxide (ITZO). In still another example, the first and second electrodes RME1 and RME2 may contain a plurality of layers including a transparent conductive material layer and a metal layer having high reflectivity, or may include one layer containing a transparent conductive material or a metal having high reflectivity. The first and second electrodes RME1 and RME2 may have a stacked structure of ITO/Ag/ITO, ITO/Ag/IZO, ITO/Ag/ITZO/IZO, and/or the like.

The first insulating layer PAS1 may be disposed on the first planarization layer OC1, and the first and second electrodes RME1 and RME2. The first insulating layer PAS1 may protect and insulate the first electrode RME1 and the second electrode RME2 from each other. The first insulating layer PAS1 may prevent damage caused by direct contact between the light emitting element ED and the first and second electrodes RME1 and RME2 in an alignment process of the light emitting element ED.

The sub-bank SB may be disposed in the light blocking area BA on the first insulating layer PAS1. The sub-bank SB may be disposed at the boundary of the plurality of pixels to distinguish the light emitting elements ED of each of the plurality of pixels. The sub-bank SB may have a suitable height (e.g., a predetermined height) and may contain an organic insulating material such as polyimide (PI).

The plurality of light emitting elements ED may be arranged on the first insulating layer PAS1. The plurality of light emitting elements ED may be arranged in parallel to each other between the first electrode RME1 and the second electrode RME2. The length of the light emitting element ED may be greater than the distance between the first electrode RME1 and the second electrodes RME2. The light emitting element ED may include a plurality of semiconductor layers, and one end thereof may be defined with respect to the first semiconductor layer, and the other end thereof opposite to the one end may be defined with respect to the second semiconductor layer. One end of the light emitting element ED may be disposed on the first electrode RME1, and the other end of the light emitting element ED may be disposed on the second electrode RME2. One end of the light emitting element ED may be electrically connected to the first electrode RME1 through the first contact electrode CTE1, and the other end of the light emitting element ED may be electrically connected to the second electrode RME2 through the second contact electrode CTE2.

The light emitting element ED may have a micro-meter or nano-meter size, and may be an inorganic light emitting diode including an inorganic material. The light emitting element ED may be aligned between the first electrode RME1 and the second electrode RME2 facing each other by the electric field formed in a specific direction between the first electrode RME1 and the second electrode RME2.

For example, a plurality of light emitting elements ED may include active layers having the same material and emit light of the same wavelength band or light of the same color. The lights emitted from the first to third emission areas LA1, LA2, and LA3 of the light emitting element layer EML may have the same color. For example, the plurality of light emitting elements ED may emit light of a third color or blue light having a peak wavelength in the range of about 440 nm to 480 nm, but the present disclosure is not limited thereto.

The second insulating layer PAS2 may be disposed on the plurality of light emitting elements ED. For example, the second insulating layer PAS2 may partially surround the plurality of light emitting elements ED and may not cover both ends of the plurality of light emitting elements ED. The second insulating layer PAS2 may protect the plurality of light emitting elements ED, and may fix the plurality of light emitting elements ED in the manufacturing process of the display device 10. The second insulating layer PAS2 may fill the space between the light emitting element ED and the first insulating layer PAS1.

The first contact electrode CTE1 may be disposed on the first insulating layer PAS1, and may be connected to the first electrode RME1 while being inserted into the contact hole formed in the first insulating layer PAS1. For example, the contact hole of the first insulating layer PAS1 may be formed on the barrier wall BP, but the disclosure is not limited thereto. One end of the first contact electrode CTE1 may be connected to the first electrode RME1 on the barrier wall BP, and the other end of the first contact electrode CTE1 may be connected to one end of the light emitting element ED.

The second contact electrode CTE2 may be disposed on the first insulating layer PAS1, and may be connected to the second electrode RME2 while being inserted into the contact hole formed in the first insulating layer PAS1. For example, the contact hole of the first insulating layer PAS1 may be formed on the barrier wall BP, but the present disclosure is not limited thereto. One end of the second contact electrode CTE2 may be connected to the other end of the light emitting element ED, and the other end of the second contact electrode CTE2 may be connected to the second electrode RME2 on the barrier wall BP.

The third insulating layer PAS3 may be disposed on the first and second contact electrodes CTE1 and CTE2, the sub-bank SB, and the first and second insulating layers PAS1 and PAS2. The third insulating layer PAS3 may be disposed at the upper end of the light emitting element layer EML to protect the light emitting element layer EML.

The wavelength conversion layer WLCL may be disposed on the light emitting element layer EML. The wavelength conversion layer WLCL may include a first light blocking member BK1, a first wavelength conversion member WLC1, a second wavelength conversion member WLC2, a light transmission member LTU, a second passivation layer PV2, a second planarization layer OC2, or the like.

The first light blocking member BK1 may be disposed in the light blocking area BA on the third insulating layer PAS3. The first blocking member BK1 may overlap the sub-bank SB in the thickness direction (e.g., the Z-axis direction). The first light blocking member BK1 may block transmission of light. The first light blocking member BK1 may prevent light infiltration and color mixture between the first to third emission areas LA1, LA2, and LA3, which leads to the improvement of color reproducibility of the display device 10. The first light blocking member BK1 may be arranged in the form of a grid surrounding the first to third emission areas LA1, LA2, and LA3 in a plan view.

The first wavelength conversion member WLC1 may be disposed in the first emission area LA1 on the third insulating layer PAS3. The first wavelength conversion member WLC1 may be surrounded by the first light blocking member BK1. The first wavelength conversion member WLC1 may change or shift the peak wavelength of the incident light to a first peak wavelength. The first wavelength conversion member WLC1 may include a first based resin BS1, a first scatterer SCT1, and a first wavelength shifter WLS1.

The first base resin BS1 may contain a material having a relatively high light transmittance. The first base resin BS1 may be formed of a transparent organic material. For example, the first base resin BS1 may contain at least one organic material selected from among epoxy resin, acrylic resin, cardo resin, and/or imide resin.

The first scatterer SCT1 may have a refractive index different from that of the first base resin BS1 and form an optical interface with the first base resin BS1. For example, the first scatterer SCT1 may contain a light scattering material or light scattering particles that scatter at least a part of the transmitted light. For example, the first scatterer SCT1 may contain a metallic oxide selected from among titanium oxide (TiO2), zirconium oxide (ZrO2), aluminum oxide (AL2O3), indium oxide (In203), zinc oxide (ZnO), and/or tin oxide (SnO2), and/or may contain organic particles such as acrylic resin and/or urethane resin. The first scatterer SCT1 may scatter light in random directions regardless of the incidence direction of the incident light without any substantial change of the peak wavelength of the incident light.

The first wavelength shifter WLS1 may change or shift the peak wavelength of the incident light to a first peak wavelength. For example, the first wavelength shifter WLS1 may convert blue light provided from the display device 10 into red light having a single peak wavelength in the range of about 610 nm to 650 nm and emit the red light. The first wavelength shifter WLS1 may be a quantum dot, a quantum rod, or a fluorescent substance. The quantum dot may be a particulate material that emits light of a specific color when an electron transitions from a conduction band to a valence band.

A part of the blue light emitted from the light emitting element layer EML may pass through the first wavelength conversion member WLC1 without being converted to red light by the first wavelength shifter WLS1. Among the blue light emitted from the light emitting element layer EML, the light incident on the first color filter CF1 without being converted by the first wavelength conversion member WLC1 may be blocked by the first color filter CF1. The red light produced by the first wavelength conversion member WLC1 converting the blue light emitted from the light emitting element layer EML may pass through the first color filter CF1 to be emitted to the outside. Accordingly, the red light may be emitted through the first emission area LA1.

The second wavelength conversion member WLC2 may be disposed in the second emission area LA2 on the third insulating layer PAS3. The second wavelength conversion member WLC2 may be surrounded by the first light blocking member BK1. The second wavelength conversion member WLC2 may change or shift the peak wavelength of the incident light to a second peak wavelength. The second wavelength conversion member WLC2 may include a second base resin BS2, a second scatterer SCT2, and a second wavelength shifter WLS2.

The second base resin BS2 may contain a material having a relatively high light transmittance. The second base resin BS2 may be formed of a transparent organic material. For example, the second base resin BS2 may be made of the same material as the first base resin BS1, or may be made of the material exemplified in association with the first base resin BS1.

The second scatterer SCT2 may have a refractive index different from that of the second base resin BS2 and form an optical interface with the second base resin BS2. For example, the second scatterer SCT2 may contain a light scattering material or light scattering particles scattering at least a part of the transmitted light. For example, the second scatterer SCT2 may be made of the same material as the first scatterer SCT1, or may be made of the material exemplified in association with the first scatterer SCT1.

The second wavelength shifter WLS2 may change or shift the peak wavelength of the incident light to a second peak wavelength different from the first peak wavelength of the first wavelength shifter WLS1. For example, the second wavelength shifter WLS2 may convert blue light provided from the display device 10 into green light having a single peak wavelength in the range of about 510 nm to 550 nm and emit the green light. The second wavelength shifter WLS2 may be a quantum dot, a quantum rod, or a fluorescent substance. The second wavelength shifter WLS2 may contain the materials exemplified in association with the first wavelength shifter WLS1. The second wavelength shifter WLS2 may be formed of a quantum dot, a quantum rod, or a fluorescent substance to have a wavelength conversion range different from that of the first wavelength shifter WLS1.

The light transmission member LTU may be disposed in the third emission area LA3 on the third insulating layer PAS3. The light transmission member LTU may be surrounded by the first light blocking member BK1. The light transmission member LTU may allow the incident light to pass therethrough while maintaining the peak wavelength of the light. The light transmission member LTU may include a third base resin BS3 and a third scatterer SCT3.

The third base resin BS3 may contain a material having a relatively high light transmittance. The third base resin BS3 may be formed of a transparent organic material. For example, the third base resin BS3 may be made of the same material as the first base resin BS1 or the second base resin BS2, or may be made of the material exemplified in association with the first base resin BS1.

The third scatterer SCT3 may have a refractive index different from that of the third base resin BS3 and form an optical interface with the third base resin BS3. For example, the third scatterer SCT3 may contain a light scattering material or light scattering particles scattering at least a part of the transmitted light. For example, the third scatterer SCT3 may be formed of the same material as the first scatterer SCT1 or the second scatterer SCT2, or may be made of the material exemplified in association with the first scatterer SCT1.

Because the wavelength conversion layer WLCL is disposed directly on the third insulating layer PAS3 of the light emitting element layer EML, the display device 10 may not require a separate substrate for the first and second wavelength conversion members WLC1 and WLC2, and the light transmission member LTU. Accordingly, the first and second wavelength conversion members WLC1 and WLC2, and the light transmission member LTU may be aligned (e.g., easily aligned) in the first to third emission areas LA1, LA2, and LA3, respectively, and the thickness of the display device 10 may be relatively reduced.

The second passivation layer PV2 may cover the first and second wavelength conversion members WLC1 and WLC2, the light transmission member LTU, and the first light blocking member BK1. For example, the second passivation layer PV2 may seal the first and second wavelength conversion members WLC1 and WLC2 and the light transmission member LTU to prevent the first and second wavelength conversion members WLC1 and WLC2 and the light transmission member LTU from damage or contamination. For example, the second passivation layer PV2 may contain an inorganic material.

The second planarization layer OC2 may be disposed on the second passivation layer PV2 to flatten the upper ends of the first and second wavelength conversion members WLC1 and WLC2, and the light transmission member LTU. For example, the second planarization layer OC2 may contain an organic insulating material such as polyimide (PI).

The color filter layer CFL may be disposed on the wavelength conversion layer WLCL. The color filter layer CFL may include a second light blocking member BK2, first to third color filters CF1, CF2, and CF3, and a third passivation layer PV3.

The second light blocking member BK2 may be disposed in the light blocking area BA on the second planarization layer OC2 of the wavelength conversion layer WLCL. The second blocking member BK2 may overlap the first blocking member BK1 or the sub-bank SB in the thickness direction (e.g., the Z-axis direction). The second light blocking member BK2 may block transmission of light. The second light blocking member BK2 may prevent light infiltration and color mixture between the first to third emission areas LA1, LA2, and LA3, which leads to the improvement of color reproducibility of the display device 10. The second light blocking member BK2 may be arranged in the form of a grid surrounding the first to third emission areas LA1, LA2, and LA3 in a plan view.

The first color filter CF1 may be disposed in the first emission area LA1 on the second planarization layer OC2. The first color filter CF1 may be surrounded by the second light blocking member BK2. The first color filter CF1 may overlap the first wavelength conversion member WLC1 in the thickness direction (e.g., the Z-axis direction). The first color filter CF1 may selectively allow the first color light (e.g., red light) to pass therethrough, and block or absorb the second color light (e.g., green light) and the third color light (e.g., blue light). For example, the first color filter CF1 may be a red color filter and contain a red colorant.

The second color filter CF2 may be disposed in the second emission area LA2 on the second planarization layer OC2. The second color filter CF₂ may be surrounded by the second light blocking member BK2. The second color filter CF2 may overlap the second wavelength conversion member WLC2 in the thickness direction (e.g., the Z-axis direction). The second color filter CF₂ may selectively allow the second color light (e.g., green light) to pass therethrough, and block or absorb the first color light (e.g., red light) and the third color light (e.g., blue light). For example, the second color filter CF2 may be a green color filter and contain a green colorant.

The third color filter CF3 may be disposed in the third emission area LA3 on the second planarization layer OC2. The third color filter CF3 may be surrounded by the second light blocking member BK2. The third color filter CF3 may overlap the light transmission member LTU in the thickness direction (e.g., the Z-axis direction). The third color filter CF3 may selectively allow the third color light (e.g., blue light) to pass therethrough, and block or absorb the first color light (e.g., red light) and the second color light (e.g., green light). For example, the third color filter CF3 may be a blue color filter and contain a blue colorant.

The first to third color filters CF1, CF2, and CF3 may absorb a part of the light coming from the outside of the display device 10 to reduce the reflected light of the external light. Thus, the first to third color filters CF1, CF2, and CF3 can prevent color distortion caused by the reflection of the external light.

Because the first to third color filters CF1, CF2, and CF3 are directly disposed on the second planarization layer OC2 of the wavelength conversion layer WLCL, the display device 10 may not require a separate substrate for the first to third color filters CF1, CF2, and CF3. Therefore, the thickness of the display device 10 may be relatively reduced.

The third passivation layer PV3 may cover the first to third color filters CF1, CF2, and CF3, and the second light blocking member BK2. The third passivation layer PV3 may protect the first to third color filters CF1, CF2, and CF3.

The encapsulation layer TFE may be disposed on the third passivation layer PV3 of the color filter layer CFL. The encapsulation layer TFE may cover the top and side surfaces of the display layer DPL. For example, the encapsulation layer TFE may include at least one inorganic layer to prevent permeation of oxygen or moisture. In addition, the encapsulation layer TFE may include at least one organic layer to protect the display device 10 from foreign substances such as dust.

The anti-reflection film ARF may be disposed on the encapsulation layer TFE. The anti-reflection film ARF may prevent reflection of external light, thereby reducing a decrease in visibility due to reflection of external light. The anti-reflection film ARF may protect the top surface of the display device 10. The anti-reflection film ARF may be omitted. For another example, the anti-reflection film ARF may be replaced with a polarizing film.

The flexible film FPCB may be disposed under the first substrate SUB1. The flexible film FPCB may be disposed on the edge of the bottom surface of the display device 10. The flexible film FPCB may be attached to the bottom surface of the first substrate SUB1 using the adhesive member ADM. The flexible film FPCB may include the lead electrode LDE disposed on the top surface of one side. The lead electrode LDE may be inserted into the opening hole OP to be electrically connected to the pad portion PAD through the connection film ACF. The flexible film FPCB may support the display driver DIC disposed on the bottom surface on the other side. The lead electrode LDE may be electrically connected to the display driver DIC through a lead line disposed on the bottom surface of the flexible film FPCB. The other side of the flexible film FPCB may be connected to a source circuit board under the first substrate SUB1. The flexible film FPCB may transmit a signal and a voltage of the display driver DIC to the display device 10.

The connection film ACF may attach the lead electrode LDE of the flexible film FPCB to the pad portion PAD. One surface of the connection film ACF may be attached to the pad portion PAD, and the other surface of the connection film ACF may be attached to the lead electrode LDE. For example, the connection film ACF may include an anisotropic conductive film. When the connection film ACF includes the anisotropic conductive film, the connection film ACF may have conductivity in a region where the pad portion PAD and the lead electrode LDE are in contact with each other, and may electrically connect the flexible film FPCB to the fan-out line FOL.

The display driver DIC may be mounted on the flexible film FPCB. The display driver DIC may be an integrated circuit (IC). The display driver DIC may convert digital video data into an analog data voltage based on the data control signal received from a timing controller, and supply the analog data voltage to the data line of the display area DA through the flexible film FPCB. The display driver DIC may supply the power voltage received from a power supply unit to the power line of the display area DA through the flexible film FPCB. The display driver DIC may generate a plurality of gate signals based on the gate control signal, and may sequentially supply the plurality of gate signals to the plurality of gate lines according to a set order. The display device 10 includes the fan-out line FOL disposed on the first substrate SUB1 and the display driver DIC disposed under the first substrate SUB1, so that the area of the non-display area NDA may be reduced or minimized.

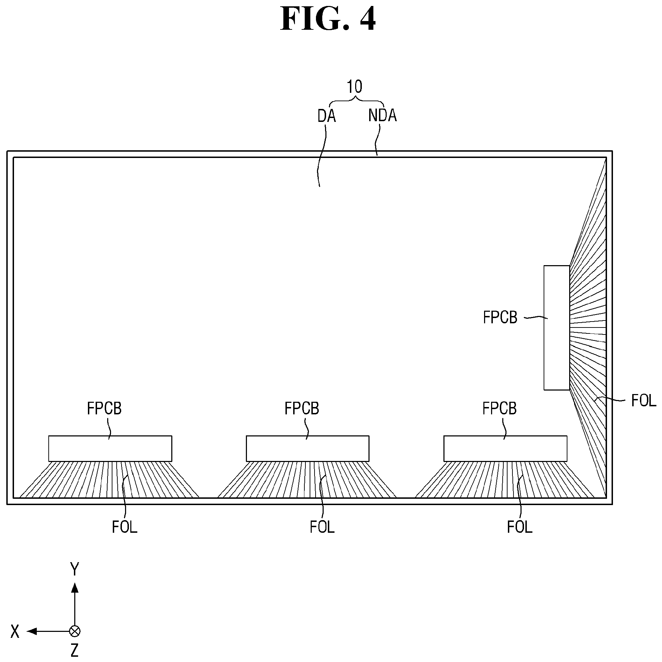

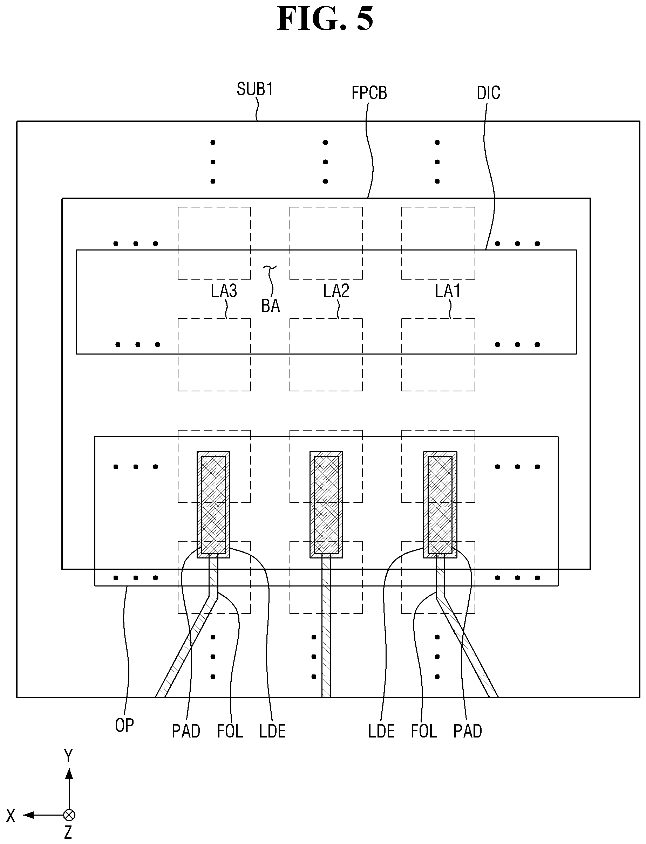

FIG. 4 is a bottom view illustrating a display device. FIG. 5 is an enlarged bottom view illustrating a part of a display device.

Referring to FIGS. 4 and 5, the flexible film FPCB, the pad portion PAD, and the fan-out line FOL may be disposed in the display area DA.

The flexible film FPCB may be disposed under the first substrate SUB1. The flexible film FPCB may be disposed on the edge of the bottom surface of the display device 10. For example, a part of the flexible film FPCB may be disposed on the edge of the long side of the display device 10, and another part of the flexible film FPCB may be disposed on the edge of the short side of the display device 10. The flexible film FPCB disposed at the edge of the long side of the display device 10 may supply the data voltage and the power voltage, and the flexible film FPCB disposed at the edge of the short side of the display device 10 may supply the gate signal, but the present disclosure is not limited thereto.

The flexible film FPCB may include the lead electrode LDE. The plurality of pad portions PAD may respectively correspond to the plurality of lead electrodes LDE. The lead electrode LDE may be electrically connected to the pad portion PAD through the connection film ACF.

The pad portion PAD may be inserted into the contact hole CNT of the first barrier insulating layer BIL1 and the second barrier insulating layer BIL2, and may be exposed through the opening hole OP. The pad portions PAD disposed at the edge of the long side of the display device 10 may be arranged along the first direction (e.g., the X-axis direction). The pad portions PAD disposed at the edge of the short side of the display device 10 may be arranged along the second direction (e.g., the Y-axis direction).

The fan-out line FOL may be integrally formed with the pad portion PAD. The fan-out line FOL may extend from the pad portion PAD to the edge of the display device 10. For example, the fan-out line FOL disposed at the edge of the long side of the display device 10 may extend in a direction opposite to the second direction (e.g., the Y-axis direction) of the flexible film FPCB. The fan-out line FOL disposed at the edge of the short side of the display device 10 may extend in a direction opposite to the first direction (e.g., the X-axis direction) of the flexible film FPCB. The fan-out line FOL may be electrically connected to the data line and/or the gate line of the display area DA through the connection portion CWL.

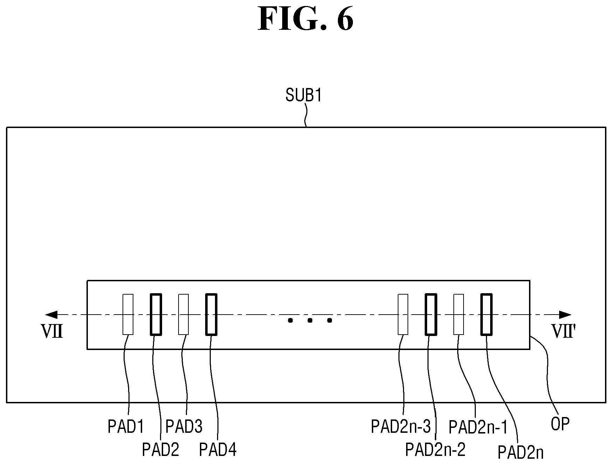

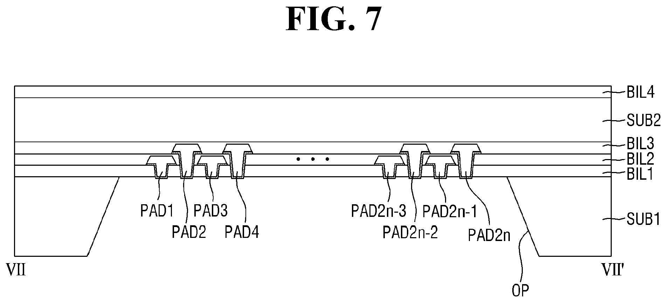

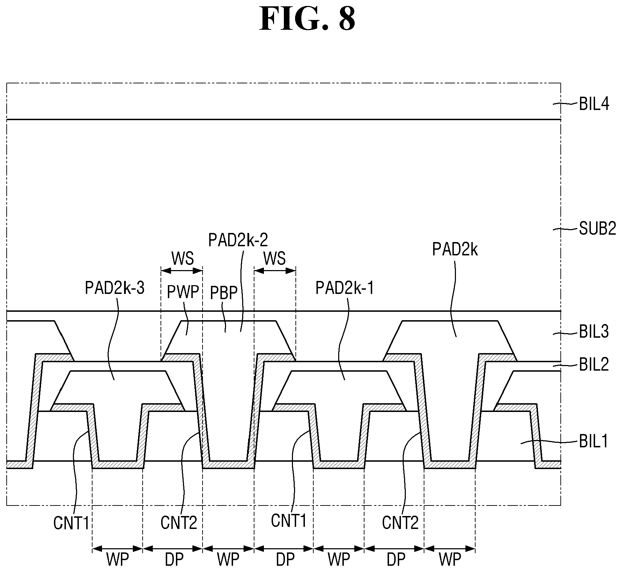

FIG. 6 is a plan view illustrating a disposition of pad portions disposed on a bottom surface of a display device. FIG. 7 is a cross-sectional view taken along the line VII-VII' of FIG. 6. FIG. 8 is an enlarged view illustrating the disposition of the pad portions of FIG. 7.

FIG. 6 illustrates the disposition of pad portions PAD1, PAD2, PAD3, PAD4, ..., PAD2n-1, and PAD2n disposed in the opening hole OP of the first substrate SUB1 at the edge of the long side of the display device 10, and FIG. 7 is a cross-sectional view of FIG. 6 and illustrates a stacked structure from the first substrate SUB1 to the fourth barrier insulating layer BIL4. FIG. 8 illustrates an enlarged version of FIG. 7 in which some of the pad portions PAD illustrated in FIG. 7 have been enlarged.

Referring to FIGS. 6 to 8, the display device 10 may include the plurality of pad portions PAD exposed through the opening hole OP formed in the bottom surface of the first substrate SUB1. The pad portions PAD may be disposed to be spaced from each other in the first direction (e.g., the X-axis direction), and may be electrically connected to the flexible film FPCB disposed on the bottom surface of the first substrate SUB1 as described above. The pad portions PAD disposed along the edge of the short side of the display device 10 may be disposed to be spaced from each other in the second direction (e.g., the Y-axis direction).

The plurality of pad portions PAD may include the odd-numbered pad portions PAD1, PAD3, ..., PAD2n-3, and PAD2n-1 (n being an integer) and the even-numbered pad portions PAD2, PAD4, ..., PAD2n-2, and PAD2n (n being an integer) alternately disposed along the first direction (e.g., the X-axis direction). When the first pad portion from one side of the first direction (e.g., the X-axis direction) is referred to as the first pad portion PAD1, the pad portion spaced from the first pad portion PAD1 in the first direction (e.g., the X-axis direction) may be the second pad portion PAD2. Next, the third pad portion PAD3 and the fourth pad portion PAD4 may be sequentially disposed to be spaced from each other in the first direction (e.g., the X-axis direction) from the second pad portion PAD2. Subsequently, the (2n-3)^{th} pad portion PAD2n-3, the (2n-2)^{th} pad portion PAD2n-2, the (2n-1)^{th} pad portion PAD2n-1, and the (2n)^{th} pad portion PAD2n may be sequentially disposed to be spaced from each other. Alternatively, as illustrated in FIG. 8, among the plurality of pad portions PAD, the (2k-3)^{th} pad portion PAD2k-3 and the (2k-1)^{th} pad portion PAD2k-1 that are odd-numbered pad portions, and the (2k-2)^{th} pad portion PAD2k-2 and the (2k)^{th} pad portion PAD2k that are even-numbered pad portions, may be alternately disposed to be spaced from each other. In this case, k is an integer.

In the display device 10, from among the plurality of pad portions PAD, the odd-numbered pad portions PAD2n-1 (n being an integer) and the even-numbered pad portions PAD2n (n being an integer) may be disposed on different layers. The first pad portion PAD1 may be the odd-numbered pad portion PAD2n-1 (n being an integer) from among the plurality of pad portions PAD, and the second pad portion PAD2 may be the even-numbered pad portion PAD2n (n being an integer) from among the plurality of pad portions PAD. Hereinafter, for simplicity of description, the odd-numbered pad portion PAD2n-1 (n being an integer) is representatively referred to as the first pad portion PAD1, and the even-numbered pad portion PAD2n (n is being integer) is representatively referred to as the second pad portion PAD2. The (2k-3)^{th} pad portion PAD2k-3 and the (2k-1)^{th} pad portion PAD2k-1 of FIG. 8 may also be representatively referred to as the first pad portion PAD1, and the (2k-2)^{th} pad portion PAD2k-2 and the (2k)^{th} pad portion PAD2k may also be representatively referred to as the second pad portion PAD2.

The first pad portion PAD1 may be disposed on the first barrier insulating layer BIL1 and may be disposed by being inserted into the first contact hole CNT1 penetrating the first barrier insulating layer BIL1. The second pad portion PAD2 may be disposed on the second barrier insulating layer BIL2 and may be disposed by being inserted into the second contact hole CNT2 penetrating the first barrier insulating layer BIL1 and the second barrier insulating layer BIL2. Pad portions arranged along one direction may have different disposed positions between adjacent pad portions.

According to the disposition of the pad portions PAD, the fan-out line FOL of the first metal layer MTL1 may be disposed on the first barrier insulating layer BIL1 or the second barrier insulating layer BIL2. From among the plurality of pad portions PAD, the first pad portion PAD1 that is the odd-numbered pad portion PAD2n-1 (n being an integer) may be disposed on the first barrier insulating layer BIL1, and the fan-out line FOL that is integrally connected to the first pad portion PAD1 may be directly disposed on the first barrier insulating layer BIL1. From among the plurality of pad portions PAD, the second pad portion PAD2 that is the even-numbered pad portion PAD2n (n being an integer) may be disposed on the second barrier insulating layer BIL2, and the fan-out line FOL that is integrally connected to the second pad portion PAD2 may be directly disposed on the second barrier insulating layer BIL2.

Each of the pad portions PAD may include a main body portion PBP disposed to be inserted into the first contact hole CNT1 and/or the second contact hole CNT2 and an extension portion PWP disposed on the first barrier insulating layer BIL1 or the second barrier insulating layer BIL2 and extending to both sides of the main body portion PBP. As the first contact hole CNT1 or the second contact hole CNT2 has a shape with a narrowing width from the upper portion toward the lower portion, the main body portion PBP of the pad portions PAD may also have a shape with a narrowing width toward the lower portion according to the above-mentioned embodiments. The pad portions PAD may further include the extension portions PWP, so that a width WP of the lower end of the main body portion PBP may be smaller than the width of the upper end of the pad portion PAD. The width of the upper end of the pad portion PAD may be the same as the sum (WP+2WS) of the width WP of the main body portion PBP and a width WS of the extension portions PWP extending to both sides.

Parts of the plurality of pad portions PAD adjacent to each other may overlap each other in a third direction ( e.g., the Z-axis direction) that is the thickness direction. The bottom surface of the main body portion PBP of the pad portion PAD may be exposed by the opening hole OP of the first substrate SUB1 on the bottom surface of the first barrier insulating layer BIL1, and may be in contact with the lead electrode LDE of the flexible film FPCB. The extension portion PWP of the pad portion PAD may overlap the extension portion PWP of the pad portion PAD disposed on another adjacent layer in the third direction (e.g., the Z-axis direction) that is the thickness direction.

For example, each of the first pad portion PAD1 and the second pad portion PAD2 may have the lower end of the main body portion PBP exposed through the opening hole OP, and the extension portion PWP of the first pad portion PAD1 may overlap the extension portion PWP of the second pad portion PAD2 in the thickness direction (e.g., the Z-axis direction). The extension portion PWP of the first pad portion PAD1 may be spaced from the main body portion PBP of the second pad portion PAD2 or the second contact hole CNT2. The lower ends of the first pad portion PAD1 and the second pad portion PAD2 may be disposed to be spaced from each other with a suitable gap (e.g., a predetermined gap) DP, but the extension portions PWP of the first pad portion PAD1 and the second pad portion PAD2 may be disposed on different layers and disposed to cross each other. As will be described later, in a plan view, the extension portion PWP of the first pad portion PAD1 and the extension portion PWP of the second pad portion PAD2 may be positioned to fill the gap DP between the lower ends of the respective pad portions PAD.

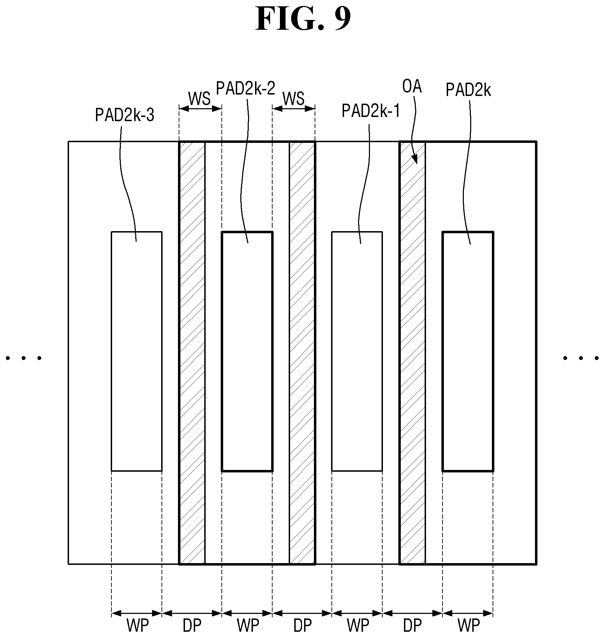

FIG. 9 is a plan view illustrating a relative disposition of first pad portions and second pad portions of a display device.

Referring to FIG. 9 in conjunction with FIG. 8, each of the pad portions PAD may include the main body portion PBP and the extension portion PWP. The lower end of the main body portion PBP of the pad portions PAD may be exposed to the opening hole OP of the first substrate SUB1, and the exposed lower end may have the first width WP. The plurality of pad portions PAD may be disposed such that the exposed lower ends thereof are spaced from each other, and may be spaced from each other by the first gap DP. In two pad portions PAD adjacent to each other, the extension portions PWP may overlap each other in the thickness direction (e.g., the Z-axis direction). The extension portion PWP may have the second width WS, and two adjacent pad portions PAD may have the extension portions PWP having the second width WS that is sufficient to fill the first gap DP between the lower ends of the main body portion PBP which are spaced in a plan view. For example, the first pad portion PAD1 or the odd-numbered pad portions PAD2k-3 and PAD2k-1 and the second pad portion PAD2 or the even-numbered pad portions PAD2k-2 and PAD2k may be disposed on different layers, but may have substantially the same shape including the main body portion PBP and the extension portion PWP, and the first width WP of the lower end of the main body portion PBP may be the same as the second width WS of one side of the extension portion PWP.

The second width WS of one side of the extension portion PWP of the first pad portion PAD1 and the second pad portion PAD2 may be smaller than the first gap DP between the lower ends of the pad portions PAD that are spaced from each other, and may have a size equal to or greater than half the first gap DP. That is, the second width WS may have a range greater than 0.5 times the first gap DP, but less than the full width of the first gap DP (e.g., the second width WS is in a range of a one half width to a full width of the first gap DP). When the second width WS is less than 0.5 times the first gap DP, the area between the adjacent pad portions PAD may not be filled. In addition, in a plan view, an overlapping area OA in which the extension portions PWP of the pad portions PAD overlap each other may not also be formed. On the other hand, when the second width WS is greater than the full width of the first gap DP, interference between the main body portion PBP and the extension portion PWP of the adjacent pad portions PAD may occur. For example, the extension portion PWP of the first pad portion PAD1 disposed on the first barrier insulating layer BIL1 may cause interference with the main body portion PBP of the second pad portion PAD2 disposed on the second barrier insulating layer BIL2. The width of the extension portion PWP of the pad portions PAD may be determined in consideration of the above-described matters. The first width WP of the lower ends of the pad portions PAD may have a size of about 15 µm, and the first gap DP therebetween may have a size of about 16 µm. The second width WS of one side of the extension portion PWP of the pad portions PAD may have a size of 8 µm to 16 µm. However, the present disclosure is not limited thereto. The first width WP and the first gap DP of the pad portions PAD may vary depending on the structure of the display device 10, and the second width WS of the pad portions PAD may vary depending on the first gap DP.

In the manufacturing process of the display device 10, the opening hole OP of the first substrate SUB1 may be formed by performing an etching process by irradiating laser. The laser irradiated from the bottom surface of the first substrate SUB1 may be absorbed by the pad portion PAD, and pass through the first to third barrier insulating layers BIL1, BIL2, and BIL3 in the area in which the pad portion PAD is not disposed. When the laser passes through the first to third barrier insulating layers BIL1, BIL2, and BIL3 and reaches the second substrate SUB2, the laser may be absorbed by the second substrate SUB2, so that the second substrate SUB2 may have a problem of lifting from (e.g., not closely adhering to) the third barrier insulating layer BIL3.

In order to prevent the above, in the display device 10, the plurality of pad portions PAD are separately disposed on different barrier insulating layers, for example, the first barrier insulating layer BIL1 and the second barrier insulating layer BIL2, so that although the laser is irradiated from the lower portion of the first barrier insulating layer BIL1, it is possible to prevent the laser from reaching the second substrate SUB2. The gap between the pad portions PAD may be covered by the extension portion PWP of the pad portions PAD, and all of the laser irradiated on the lower portion of the first barrier insulating layer BIL1 during the process of etching the first substrate SUB1 may be absorbed by the pad portion PAD. In the display device 10, the disposition of the pad portions PAD may be designed such that the laser is absorbed by the pad portion PAD in the laser process of etching the first substrate SUB1, and accordingly, the second substrate SUB2 may be prevented from being lifted or the damage to the second substrate SUB2 and the display layer DPL may be prevented.

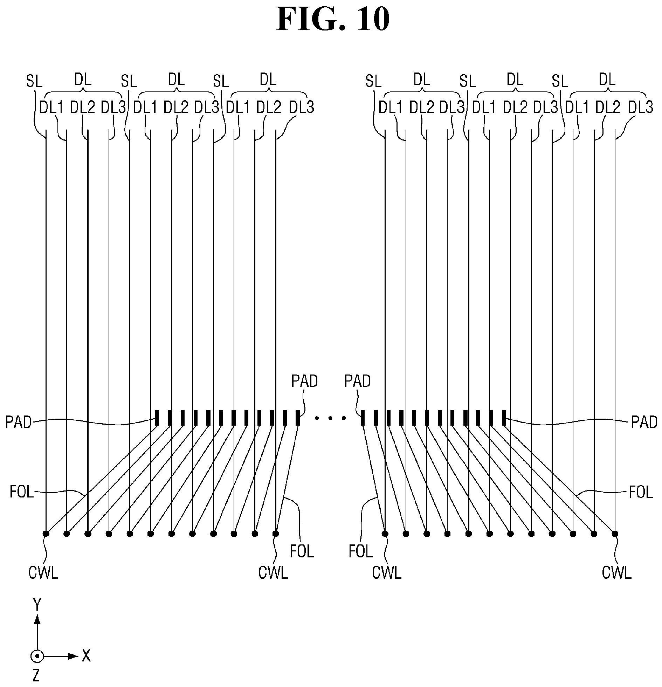

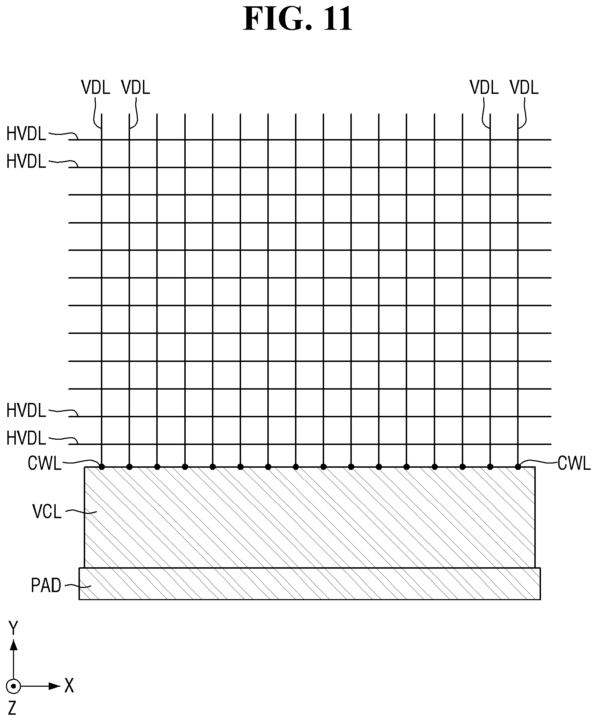

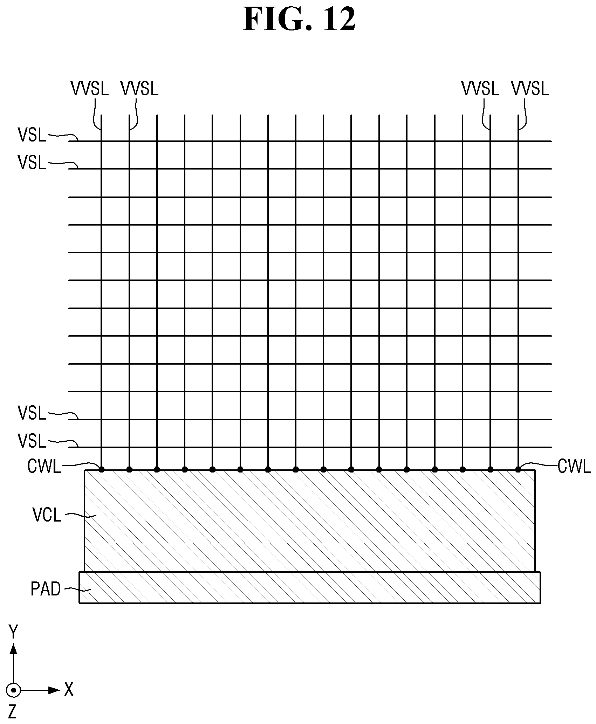

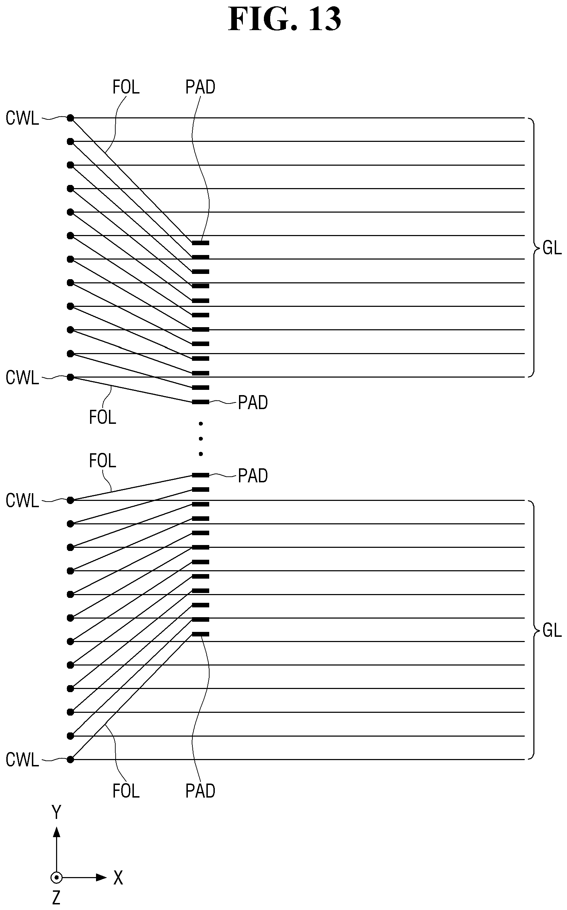

FIG. 10 is a view illustrating a pad portion, a fan-out line, a sensing line, and a data line in a display device, and FIG. 11 is a view illustrating a pad portion, a power connection line, a high potential line, and a horizontal voltage line in a display device. FIG. 12 is a view illustrating a pad portion, a power connection line, a low potential line, and a vertical voltage line in a display device, and FIG. 13 is a view illustrating a pad portion, a fan-out line, and a gate line in the display device.

Referring to FIGS. 10 to 13, the display area DA may include a sensing line SL, a data line DL, a high potential line VDL, a horizontal voltage line HVDL, a low potential line VSL, a vertical voltage line VVSL, and a gate line GL.

The plurality of sensing lines SL may extend in the second direction (e.g., the Y-axis direction) and may be spaced from each other in the first direction (e.g., the X-axis direction). Referring also to FIG. 2, the sensing line SL may be disposed in the second metal layer MTL2 and extend in the second direction (e.g., the Y-axis direction). The sensing line SL may be electrically connected to the fan-out line FOL of the first metal layer MTL1 through the connection portion CWL. The sensing line SL may cross the fan-out line FOL in a plan view. The sensing line SL may receive an initialization voltage through the pad portion PAD. The sensing line SL may provide a sensing signal to the pad portion PAD.

The data lines DL may include first to third data lines DL1, DL2, and DL3. The first to third data lines DL1, DL2, and DL3 may extend in the second direction (e.g., the Y-axis direction) and may be spaced from each other in the first direction (e.g., the X-axis direction). Referring also to FIG. 2, the data line DL may be disposed in the second metal layer MTL2 and extend in the second direction (e.g., the Y-axis direction). The data line DL may be electrically connected to the fan-out line FOL of the first metal layer MTL1 through the connection portion CWL. The data line DL may cross the fan-out line FOL in a plan view. The data line DL may receive a data voltage through the pad portion PAD.

The plurality of high potential lines VDL may extend in the second direction (e.g., the Y-axis direction) and may be spaced from each other in the first direction (e.g., the X-axis direction). The high potential lines VDL may be connected to horizontal voltage lines HVDL crossing them, and may supply a high potential voltage to the horizontal voltage lines HVDL. Referring also to FIG. 2, the high potential line VDL may be disposed in the second metal layer MTL2 and extend in the second direction (e.g., the Y-axis direction). The high potential line VDL may be electrically connected to a power connection line VCL of the first metal layer MTL1 through the connection portion CWL. The high potential line VDL may receive a high potential voltage through the pad portion PAD.

The plurality of horizontal voltage lines HVDL may extend in the first direction (e.g., the X-axis direction) and may be spaced from each other in the second direction (e.g., the Y-axis direction). The horizontal voltage lines HVDL may be connected to the high potential lines VDL crossing them, and may receive a high potential voltage from the high potential lines VDL. Referring also to FIG. 2, the horizontal voltage line HVDL may be disposed in the fourth metal layer MTL4 and extend in the first direction (e.g., the X-axis direction).

The plurality of vertical voltage lines VVSL may extend in the second direction (e.g., the Y-axis direction) and may be spaced from each other in the first direction (e.g., the X-axis direction). The vertical voltage lines VVSL may be connected to the low potential lines VSL crossing them, and may supply a low potential voltage to the low potential lines VSL. Referring also to FIG. 2, the vertical voltage line VVSL may be disposed in the second metal layer MTL2 and extend in the second direction (e.g., the Y-axis direction). The vertical voltage line VVSL may be electrically connected to the power connection line VCL of the first metal layer MTL1 through the connection portion CWL. The vertical voltage line VVSL may receive a low potential voltage through the pad portion PAD.

The plurality of low potential lines VSL may extend in the first direction (e.g., the X-axis direction) and may be spaced from each other in the second direction (e.g., the Y-axis direction). The low potential lines VSL may be connected to the vertical voltage lines VVSL crossing them, and may receive a low potential voltage from the vertical voltage lines VVSL. Referring also to FIG. 2, the low potential line VSL may be disposed in the fourth metal layer MTL4 and extend in the first direction (e.g., the X-axis direction).

The plurality of gate lines GL may extend in the first direction (e.g., the X-axis direction) and may be spaced from each other in the second direction (e.g., the Y-axis direction). Referring also to FIG. 2, the gate line GL may be disposed in the third metal layer MTL3 or the fourth metal layer MTL4 and extend in the first direction (e.g., the X-axis direction). The gate line GL may be electrically connected to the fan-out line FOL of the first metal layer MTL1 through the connection portion CWL. The gate line GL may cross the fan-out line FOL in a plan view. The gate line GL may receive the gate signal through the pad portion PAD.

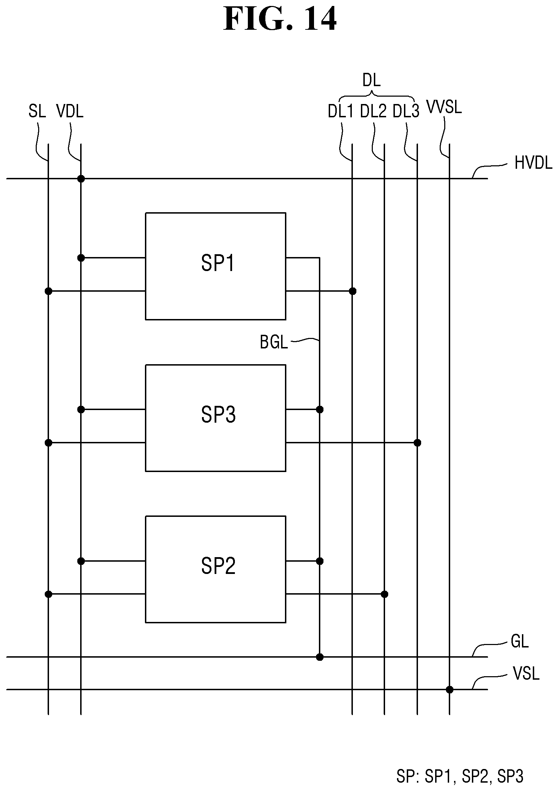

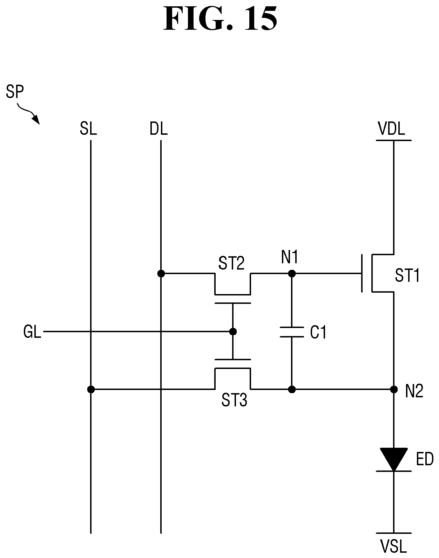

FIG. 14 is a block diagram illustrating pixels and lines in a display device. FIG. 15 is a circuit diagram illustrating the pixel of FIG. 14.

Referring to FIGS. 14 and 15, the pixels SP may include first to third pixels SP1, SP2, and SP3. The pixel circuits of the first pixel SP1, the third pixel SP3 and the second pixel SP2 may be arranged along the opposite direction of the second direction (e.g., the Y-axis direction), but the arrangement direction of the pixel circuits is not limited thereto.

Each of the first to third pixels SP1, SP2, and SP3 may be connected to the high potential line VDL, the sensing line SL, the gate line GL, and the data line DL.

The high potential line VDL may extend in the second direction (e.g., the Y-axis direction). The high potential line VDL may be disposed on the left side of the pixel circuits of the first to third pixels SP1, SP2, and SP3. The high potential line VDL may supply a high potential voltage to a transistor of each of the first to third pixels SP1, SP2 and SP3.

The horizontal voltage line HVDL may extend in the first direction (e.g., the X-axis direction). The horizontal voltage line HVDL may be disposed on the upper side of the pixel circuit of the first pixel SP1. The horizontal voltage line HVDL may be connected to the high potential line VDL. The horizontal voltage line HVDL may receive a high potential voltage from the high potential line VDL.

A sensing line SL may extend in the second direction (e.g., the Y-axis direction). The sensing line SL may be disposed on the left side of the high potential line VDL. The sensing line SL may supply an initialization voltage to the pixel circuit of each of the first to third pixels SP1, SP2, and SP3. The sensing line SL may receive a sensing signal from the pixel circuit of each of the first to third pixels SP1, SP2, and SP3 to supply the sensing signal the display driver DIC.

A gate line GL may extend in the first direction (e.g., the X-axis direction). Referring also to FIG. 2, the gate line GL may be disposed in the third metal layer MTL3 or the fourth metal layer MTL4. The gate line GL may be disposed on the lower side of the pixel circuit of the second pixel SP2. The gate line GL may be disposed on the upper side of the low potential line VSL. The gate line GL may supply the gate signal to an auxiliary gate line BGL.

The auxiliary gate line BGL may extend from the gate line GL in the second direction (e.g., the Y-axis direction). Referring also to FIG. 2, the auxiliary gate line BGL may be disposed in the third metal layer MTL3. A part of the auxiliary gate line BGL may be the gate electrode GE of a second transistor ST2, and another part of the auxiliary gate line BGL may be the gate electrode GE of a third transistor ST3. The auxiliary gate line BGL may be disposed on the right side of the pixel circuits of the first to third pixels SP1, SP2, and SP3. The auxiliary gate line BGL may supply the gate signals received from the gate line GL to the pixel circuits of the first to third pixels SP1, SP2, and SP3.

The data line DL may extend in the second direction (e.g., the Y-axis direction). The data line DL may supply a data voltage to the pixel SP. The data lines DL may include first to third data lines DL1, DL2, and DL3.

The first data line DL1 may extend in the second direction (e.g., the Y-axis direction). The first data line DL1 may be disposed on the right side of the auxiliary gate line BGL. The first data line DL1 may supply the data voltage received from the display driver DIC to the pixel circuit of the first pixel SP1.

The second data line DL2 may extend in the second direction (e.g., the Y-axis direction). The second data line DL2 may be disposed on the right side of the first data line DL1. The second data line DL2 may supply the data voltage received from the display driver DIC to the pixel circuit of the second pixel SP2.

The third data line DL3 may extend in the second direction (e.g., the Y-axis direction). The third data line DL3 may be disposed on the right side of the second data line DL2. The third data line DL3 may supply the data voltage received from the display driver DIC to the pixel circuit of the third pixel SP3.

The vertical voltage line VVSL may extend in the second direction (e.g., the Y-axis direction). The vertical voltage line VVSL may be disposed on the right side of the third data line DL3. The vertical voltage line VVSL may be connected to the low potential line VSL and may supply a low potential voltage to the low potential line VSL.

The low potential line VSL may extend in the first direction (e.g., the X-axis direction). The low potential line VSL may be disposed on the lower side of the gate line GL. The low potential line VSL may supply the low potential voltage received from the vertical voltage line VVSL to the light emitting element ED of the first to third pixels SP1, SP2, and SP3.

Each of the first to third pixels SP1, SP2, and SP3 may include a pixel circuit and the light emitting element ED. The pixel circuit of each of the first to third pixels SP1, SP2, and SP3 may include first to third transistors ST1, ST2, and ST3 and a first capacitor C1.

The first transistor ST1 may include a gate electrode, a drain electrode, and a source electrode. The gate electrode of the first transistor ST1 may be connected to a first node N1, the drain electrode thereof may be connected to the high potential line VDL, and the source electrode thereof may be connected to a second node N2. The first transistor ST1 may control a drain-source current (or driving current) based on a data voltage applied to the gate electrode of the first transistor ST1.

The light emitting element ED may include at least one light emitting element ED. When the light emitting element ED includes the plurality of light emitting elements ED, the plurality of light emitting elements ED may be connected in series or in parallel. The light emitting element ED may receive a driving current from the first transistor ST1 to emit light. The light emission amount or the luminance of the light emitting element ED may be proportional to the magnitude of the driving current. The light emitting element ED may be an inorganic light emitting element including an inorganic semiconductor, but is not limited thereto.

The first electrode of the light emitting element ED may be connected to the second node N2, and the second electrode of the light emitting element ED may be connected to the low potential line VSL. The first electrode of the light emitting element ED may be connected to the source electrode of the first transistor ST1, the drain electrode of the third transistor ST3, and the second capacitor electrode of the first capacitor C1, through the second node N2.

The second transistor ST2 may be turned on by the gate signal of the gate line GL to electrically connect the data line DL to the first node N1 which is the gate electrode of the first transistor ST1. The second transistor ST2 may be turned on according to the gate signal to supply the data voltage to the first node N1. The gate electrode of the second transistor ST2 may be connected to the gate line GL, the drain electrode thereof may be connected to the data line DL, and the source electrode thereof may be connected to the first node N1.

The third transistor ST3 may be turned on by the gate signal of the gate line GL to electrically connect the sensing line SL to the second node N2 which is the source electrode of the first transistor ST1. When the third transistor ST3 is turned on in response on the gate signal, the initialization voltage may be supplied to the second node N2 and the sensing signal may be supplied to the sensing line SL. The gate electrode of the third transistor ST3 may be connected to the gate line GL, the drain electrode thereof may be connected to the second node N2, and the source electrode thereof may be connected to the sensing line SL.

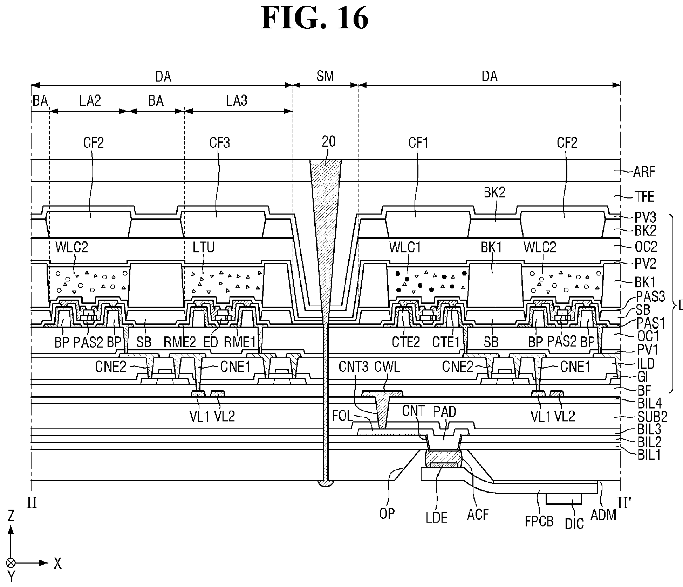

FIG. 16 is a cross-sectional view taken along the line II-II' of FIG. 1.

Referring to FIG. 16, the tiled display device TD may include the plurality of display devices 10 and a bonding member 20. The tiled display device TD may include first to fourth display devices 10-1 to 10-4. The number and connection relationship of the display devices 10 are not limited to that shown in FIG. 1. The number of the display devices 10 may be determined according to the size of each of the display devices 10 and the tiled display device TD.

The display device 10 may include a display area DA and a non-display area NDA. The display area DA may include a plurality of pixels SP to display an image. The non-display area NDA may be disposed around the display area DA to surround the display area DA, and may not display an image.

The tiled display device TD may include a coupling area SM disposed between a plurality of display areas DA. The tiled display device TD may be formed by connecting non-display areas NDA of the adjacent display devices 10. The plurality of display devices 10 may be connected to each other through the bonding member 20 or an adhesive member disposed in the coupling area SM. The coupling area SM of each of the plurality of display devices 10 may not include a pad member or a fan-out line connected to the pad member. Accordingly, the distance between the display areas DA of the plurality of display devices 10 may be small enough that the coupling area SM is not recognized by the user. Further, the reflectance of external light of the display areas DA of the plurality of display devices 10 may be substantially the same as that of the coupling area SM. Accordingly, in the tiled display device TD, the coupling area SM between the plurality of display devices 10 may be prevented from being recognized by the user, thereby reducing a sense of disconnection between the plurality of display devices 10 and improving a sense of immersion in an image.

The tiled display device TD may bond the side surfaces of the adjacent display devices 10 to each other by using the bonding member 20 disposed between the plurality of display devices 10. The bonding member 20 may connect the side surfaces of the first to fourth display devices 10-1 to 10-4 arranged in a grid form to implement the tiled display device TD. The bonding member 20 may bond the side surfaces of the first substrates SUB1, the side surfaces of the first to third barrier insulating layers BIL1, BIL2, and BIL3, the side surfaces of the second substrates SUB2, the side surfaces of the fourth barrier insulating layers BIL4, the side surfaces of the display layers DPL, the side surfaces of the encapsulation layers TFE, and the side surfaces of the anti-reflection films ARF of the display devices 10 adjacent to each other.

For example, the bonding member 20 may be made of an adhesive or a double-sided tape having a relatively low thickness to reduce or minimize the gap between the plurality of display devices 10. For another example, the bonding member 20 may be formed of a bonding frame having a relatively low thickness to reduce or minimize the gap between the plurality of display devices 10. Accordingly, in the tiled display device TD, it is possible to prevent the user from recognizing the coupling area SM between the plurality of display devices 10.

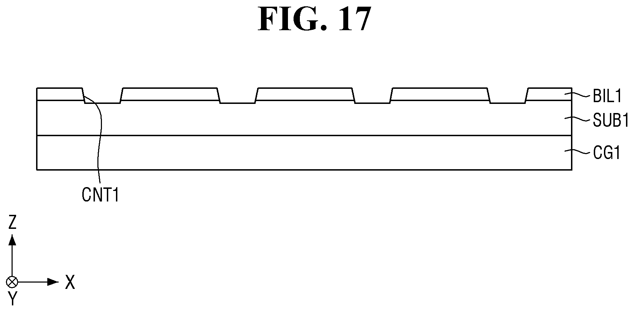

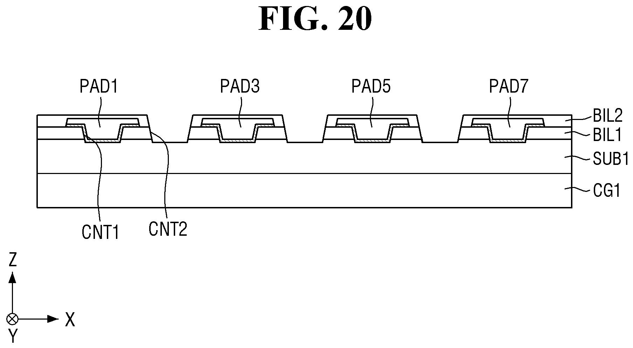

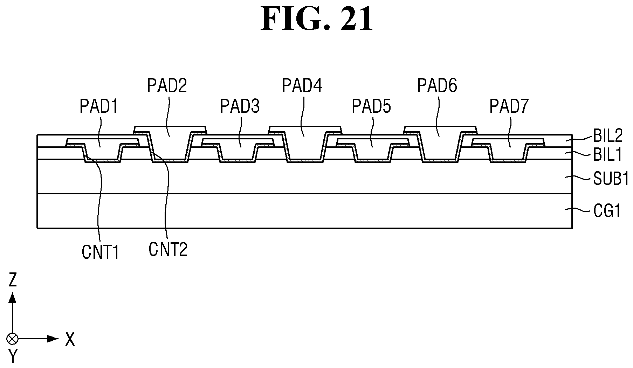

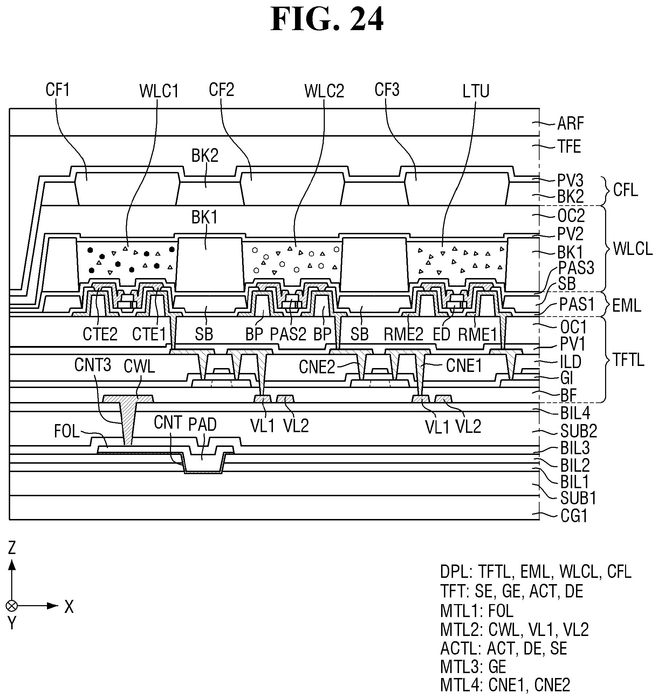

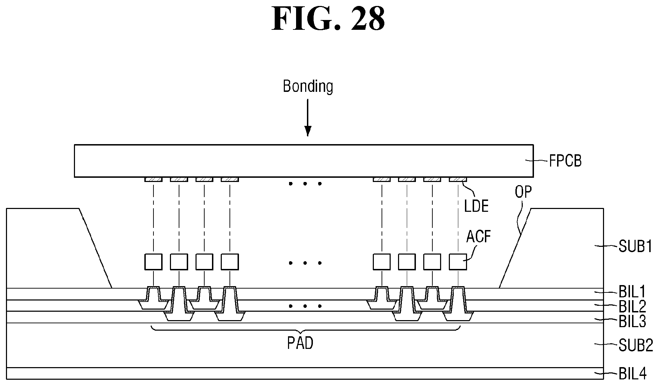

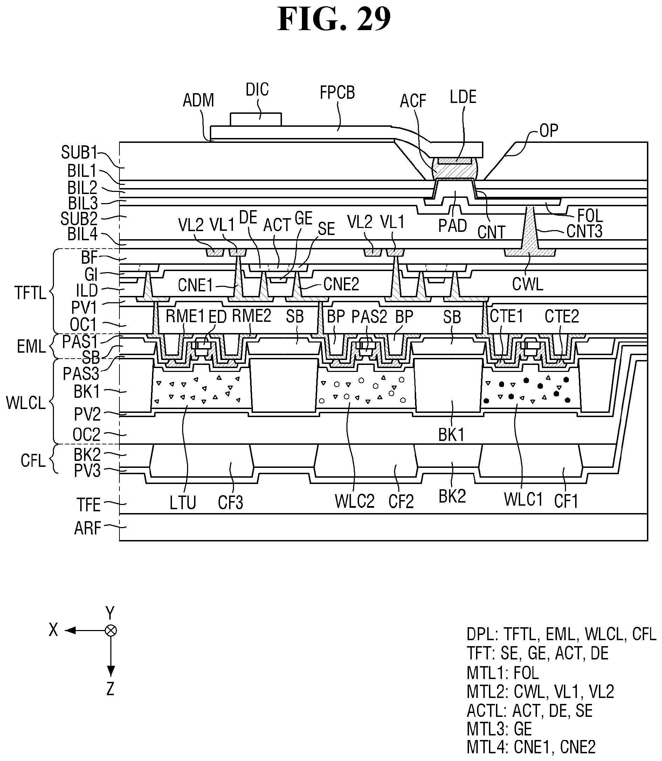

FIGS. 17 to 29 are cross-sectional views illustrating a manufacturing process of a display device. FIGS. 17 to 23 schematically illustrate a process of forming the pad portions PAD, and FIGS. 24 to 29 schematically illustrate a process of forming the display layer DPL and a laser process of forming the opening hole OP in the first substrate SUB1. Hereinafter, with respect to the manufacturing process of the display device 10, a description of the formation process of each layer will be omitted, and the formation order of each layer will be described.

Referring to FIG. 17, the first substrate SUB1 and a first carrier substrate CG1 on which the first barrier insulating layer BIL1 is disposed are prepared, and the first contact hole CNT1 penetrating the first barrier insulating layer BIL1 is formed.

A first carrier substrate CG1 may support the display device 10 in the manufacturing process of the display device 10. For example, the first carrier substrate CG1 may be a carrier glass, but is not limited thereto. The first substrate SUB1 may be disposed on the first carrier substrate CG1, and the first barrier insulating layer BIL1 may be disposed on the first substrate SUB1. Descriptions of these materials, thicknesses, and/or the like are the same as those described above, and thus will be omitted.

The first contact hole CNT1 may be formed to penetrate the first barrier insulating layer BIL1 and recess a part of the top surface of the first substrate SUB1. A portion of the pad portions PAD disposed in the first contact hole CNT1 may be formed to protrude from the bottom surface of the first barrier insulating layer BIL1.

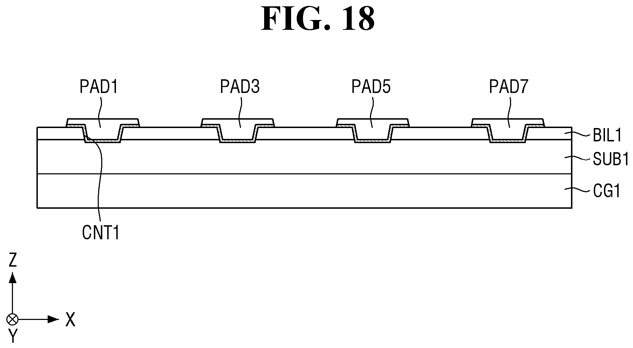

Next, referring to FIG. 18, the odd-numbered pad portions PAD1, PAD3, PAD5, and PAD7 are formed in the first contact hole CNT1. Each of the first pad portion PAD1, the third pad portion PAD3, the fifth pad portion PAD5, and the seventh pad portion PAD7 is an odd-numbered pad portion and may be disposed on the first barrier insulating layer BIL1. As described above, each of the first pad portion PAD1, the third pad portion PAD3, the fifth pad portion PAD5, and the seventh pad portion PAD7 may be formed of a double layer including a lower metal layer and an upper metal layer, the main body portion may be disposed to be inserted into the first contact hole CNT1, and the extension portion PWP may be directly disposed on the first barrier insulating layer BIL1. As the first contact hole CNT1 is formed such that a portion of the top surface of the first substrate SUB1 is recessed, each of the first pad portion PAD1, the third pad portion PAD3, the fifth pad portion PAD5, and the seventh pad portion PAD7 may be formed to be in contact with the recessed portion of the first substrate SUB1. Each of the first pad portion PAD1, the third pad portion PAD3, the fifth pad portion PAD5, and the seventh pad portion PAD7 may be formed such that a bottom surface thereof protrudes from the bottom surface of the first barrier insulating layer BIL1.

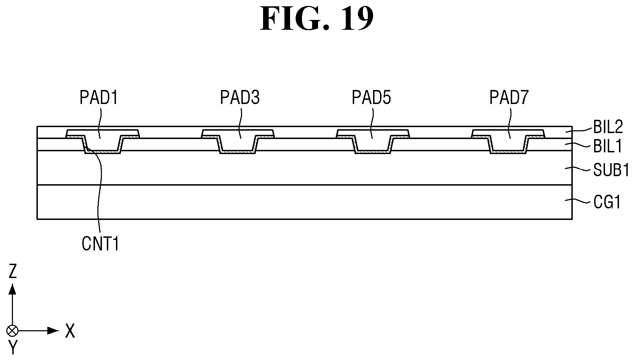

Next, referring to FIGS. 19 to 21, the second barrier insulating layer BIL2 may be formed on the first barrier insulating layer BIL1 and odd-numbered pad portions, the second contact hole CNT2 penetrating the first barrier insulating layer BIL1 and the second barrier insulating layer BIL2 may be formed, and then even-numbered pad portions PAD2, PAD4, and PAD6 may be formed.

The second barrier insulating layer BIL2 may be disposed on the first barrier insulating layer BIL1 to be disposed to cover the odd-numbered pad portions PAD1, PAD3, PAD5, and PAD7. Because the description of the material, thickness, or the like of the second barrier insulating layer BIL2 is the same as described above, it will be omitted.

The second contact hole CNT2 may be formed to penetrate the first barrier insulating layer BIL1 and the second barrier insulating layer BIL2 and recess a portion of the top surface of the first substrate SUB1. A portion of the pad portions PAD disposed in the second contact hole CNT2 may be formed to protrude from the bottom surface of the first barrier insulating layer BIL1. The second contact holes CNT2 may be formed between the first contact holes CNT1 spaced from each other. The adjacent first contact hole CNT1 and second contact hole CNT2 may be formed to be spaced from each other.

Each of the second pad portion PAD2, the fourth pad portion PAD4, and the sixth pad portion PAD6 may be an even-numbered pad portion and may be disposed on the second barrier insulating layer BIL2. As described above, each of the second pad portion PAD2, the fourth pad portion PAD4, and the sixth pad portion PAD6 may be formed of a double layer including a lower metal layer and an upper metal layer, the main body portion may be disposed to be inserted into the second contact hole CNT2, and the extension portion PWP may be directly disposed on the second barrier insulating layer BIL2. As the second contact hole CNT2 is formed such that a portion of the top surface of the first substrate SUB1 is recessed, each of the second pad portion PAD2, the fourth pad portion PAD4, and the sixth pad portion PAD6 may be formed to be in contact with the recessed portion of the first substrate SUB1. Each of the second pad portion PAD2, the fourth pad portion PAD4, and the sixth pad portion PAD6 may be formed such that a bottom surface thereof protrudes from the bottom surface of the first barrier insulating layer BIL1.

The adjacent odd-numbered pad portions PAD1, PAD3, PAD5, and PAD7 and even-numbered pad portions PAD2, PAD4, and PAD6 may be disposed on different layers and may be alternately disposed. The pad portions PAD adjacent to each other while being disposed on different layers may be spaced from each other but may be disposed such that the extension portions PWP overlap each other in the thickness direction (e.g., the Z-axis direction). Because a description thereof is the same as described above, a detailed description thereof will be omitted.

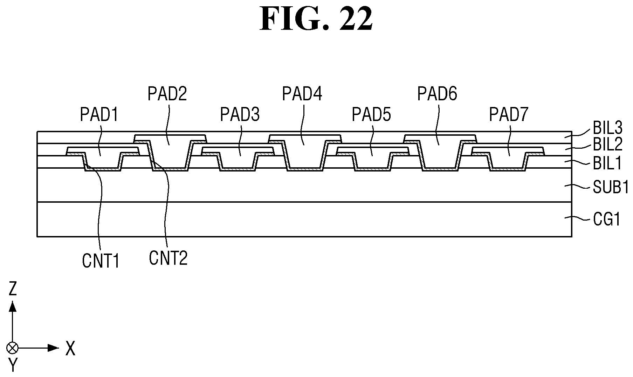

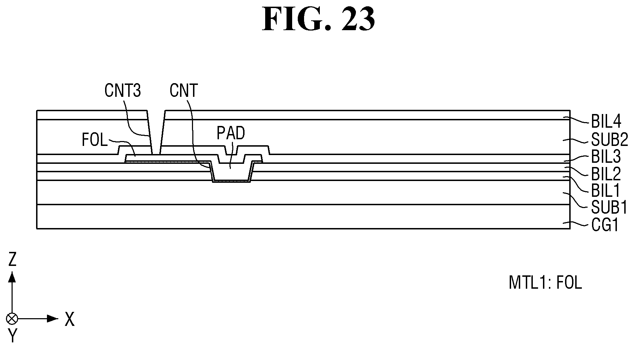

Next, referring to FIGS. 22 and 23, the third barrier insulating layer BIL3 is formed on the second barrier insulating layer BIL2 and the even-numbered pad portions PAD2, PAD4, and PAD6, the second substrate SUB2 and the fourth barrier insulating layer BIL4 are formed on the third barrier insulating layer BIL3, and then the third contact hole CNT3 is formed.

The third barrier insulating layer BIL3 may be disposed on the second barrier insulating layer BIL2 and the fan-out line FOL. The third barrier insulating layer BIL3 may include an inorganic layer capable of preventing permeation of air or moisture. Corresponding to the pad portion PAD, the fan-out line FOL may be disposed on the same layer as the pad portion PAD. For example, the fan-out line FOL integrated with the odd-numbered pad portions PAD1, PAD3, PAD5, and PAD7 may be disposed on the first barrier insulating layer BIL1, and the fan-out line FOL integrated with the even-numbered pad portions PAD2, PAD4, and PAD6 may be disposed on the second barrier insulating layer BIL2.

The second substrate SUB2 and the fourth barrier insulating layer BIL4 may be sequentially stacked on the third barrier insulating layer BIL3. The third contact hole CNT3 may be etched from the top surface of the fourth barrier insulating layer BIL4 to penetrate the bottom surface of the third barrier insulating layer BIL3. For example, the third and fourth barrier insulating layers BIL3 and BIL4 and the second substrate SUB2 may be penetrated through a dry etching process or a wet etching process, but the present disclosure is not limited thereto. The top surface of the fan-out line FOL may be exposed by the third contact hole CNT3.

Some of the third contact holes CNT3 may penetrate the second barrier insulating layer BIL2 to expose a portion of the top surface of the fan-out line FOL of the odd-numbered pad portions PAD1, PAD3, PAD5, and PAD7. Some other third contact holes CNT3 may penetrate the third barrier insulating layer BIL3 to expose a portion of the top surface of the fan-out line FOL of the even-numbered pad portions PAD2, PAD4, and PAD6.

Referring to FIG. 24, the display layer DPL may be stacked on the fourth barrier insulating layer BIL4. The thin film transistor layer TFTL, the light emitting element layer EML, the wavelength conversion layer WLCL, and the color filter layer CFL may be sequentially stacked on the fourth barrier insulating layer BIL4. The encapsulation layer TFE may cover the top and side surfaces of the display layer DPL. The anti-reflection film ARF may be formed on the encapsulation layer TFE.

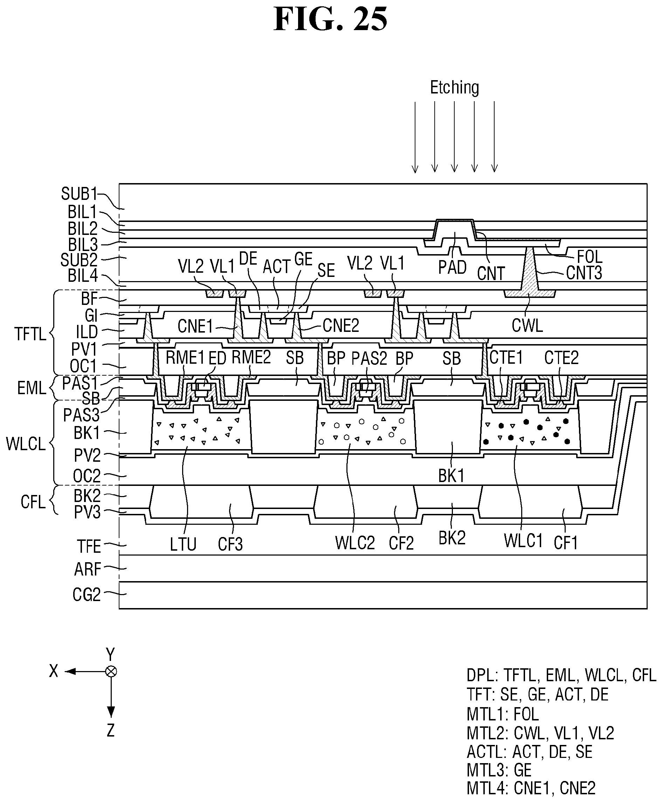

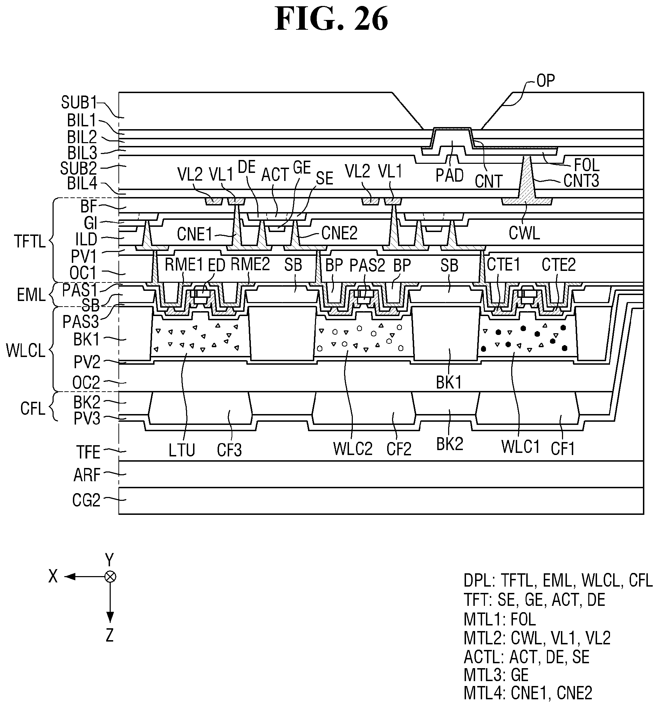

Referring to FIGS. 25 and 26, the display device 10 being manufactured may be vertically inverted to attach the flexible film FPCB. The first carrier substrate CG1 may be removed from the first substrate SUB1. For example, the first carrier substrate CG1 may be removed from the bottom surface of the first substrate SUB1 using a sacrificial layer disposed between the first carrier substrate CG1 and the first substrate SUB1, but the present disclosure is not limited thereto.

A second carrier substrate CG2 may be disposed on one surface of the anti-reflection film ARF. The second carrier substrate CG2 may support the vertically inverted display device 10. For example, the second carrier substrate CG2 may be a carrier glass, but is not limited thereto.

One surface of the first substrate SUB1 may be subjected to a laser etching process. The ultraviolet laser may have a wavelength of about 300 nm to 400 nm, preferably, a wavelength of about 340 nm to 350 nm. The opening hole OP may be formed in the first substrate SUB1 to expose a part of the first barrier insulating layer BIL1 and the pad portion PAD. The pad portions PAD may absorb ultraviolet laser in the etching process of the first substrate SUB1 to prevent transmission of the ultraviolet laser. As the pad portions PAD disposed on different layers cross each other and the extension portions PWP are disposed to overlap each other, the irradiated laser may not penetrate at least the second barrier insulating layer BIL2 and may be absorbed by the pad portion PAD. The plurality of pad portions PAD may absorb the ultraviolet laser in the etching process of the first substrate SUB1, thereby preventing damage to the second substrate SUB2 or the display layer DPL.

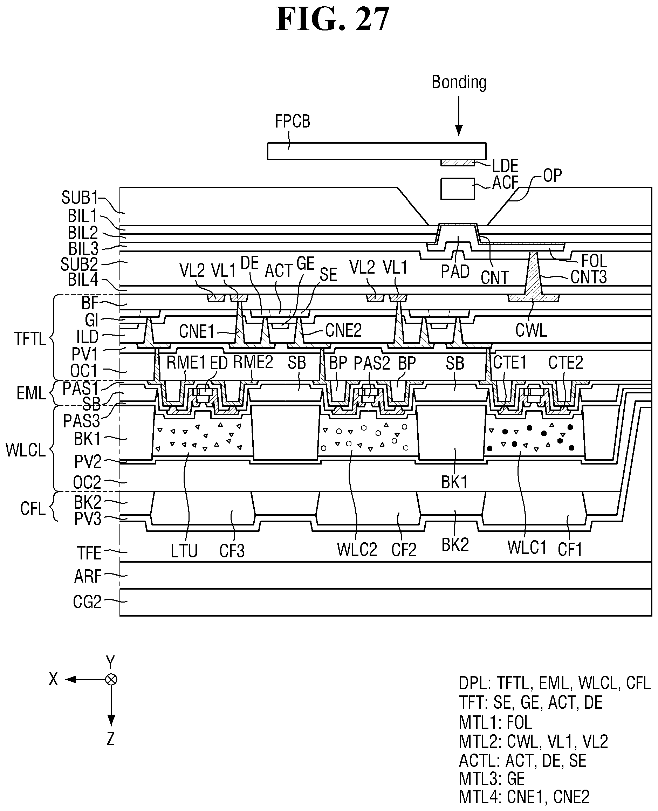

In FIGS. 27 to 29, the flexible film FPCB may be disposed on one surface of the first substrate SUB1. The flexible film FPCB and the lead electrode LDE may be aligned on the pad portion PAD through an alignment process. For example, the lead electrode LDE of the flexible film FPCB may be attached to the pad portion PAD through ultrasonic bonding or thermocompression bonding, but the bonding method is not limited thereto. The connection film ACF may have conductivity in a region where the pad portion PAD and the lead electrode LDE are in contact with each other, and may electrically connect the flexible film FPCB to the pad portion PAD.

Hereinafter, other implementations of the display device 10 will be described with reference to other drawings.

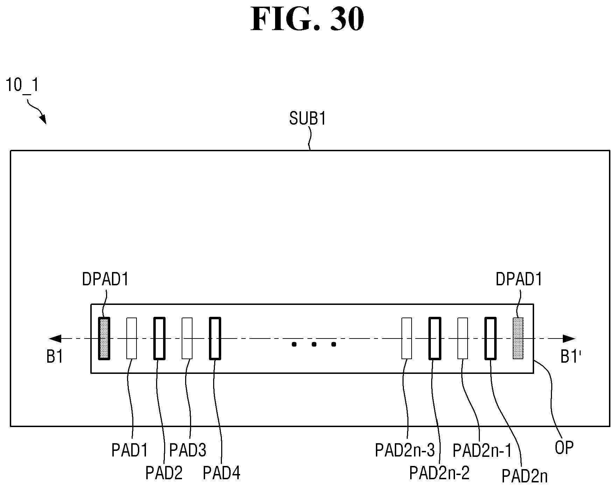

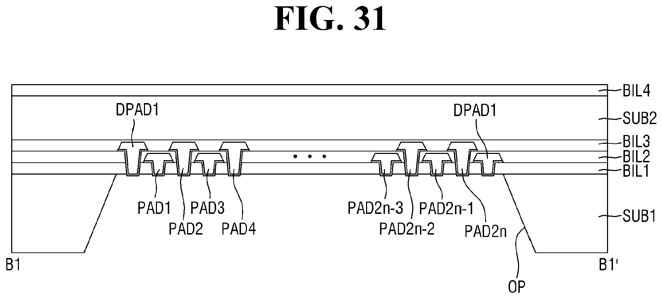

FIG. 30 is a plan view illustrating a disposition of pad portions disposed on a bottom surface of a display device. FIG. 31 is a cross-sectional view taken along the line B1-B1' in FIG. 30. FIG. 30 illustrates the disposition of the pad portions PAD1, PAD2, PAD3, PAD4, ..., PAD2n-1, and PAD2n and a first dummy pad portion DPAD1 disposed in the opening hole OP of the first substrate SUB1 at the edge of the long side of a display device 10_1, and FIG. 31 is a cross-sectional view of FIG. 30 and illustrates a stacked structure from the first substrate SUB1 to the fourth barrier insulating layer BIL4.

Referring to FIGS. 30 and 31, the display device 10_1 may further include the first dummy pad portions DPAD1 in addition to the plurality of pad portions PAD. The display device 10_1 may include the plurality of pad portions PAD exposed through the opening hole OP formed in the bottom surface of the first substrate SUB1 and a plurality of first dummy pad portions DPAD1 adjacent to and spaced from the pad portion, from among the pad portions PAD, disposed at an edge of the direction in which the pad portions PAD are arranged, for example, the first pad portion PAD1 or the (2n)^{th} pad portion PAD2n. The pad portions PAD may be disposed to be spaced from each other in the first direction (e.g., the X-axis direction), and may be electrically connected to the flexible film FPCB disposed on the bottom surface of the first substrate SUB1.

The plurality of pad portions PAD may include the odd-numbered pad portions PAD1, PAD3, ..., PAD2n-3, and PAD2n-1 (n being an integer) and the even-numbered pad portions PAD2, PAD4, ..., PAD2n-2, and PAD2n (n being an integer) alternately disposed along the first direction (e.g., the X-axis direction). Because the description thereof is the same as the above description with reference to FIGS. 6 to 8, the detailed description thereof will be omitted.

The first dummy pad portions DPAD1 may be disposed to be spaced from any one of the pad portions PAD. The first dummy pad portions DPAD1 may also be disposed to overlap the opening hole OP of the first substrate SUB1, and a lower end may be exposed by the opening hole OP. However, the plurality of first dummy pad portions DPAD1 may have substantially the same shape as the pad portions PAD and may be arranged together with the pad portions PAD along the first direction (e.g., the X-axis direction), but may not be electrically connected to the flexible film FPCB disposed on the bottom surface of the first substrate SUB1. The lead electrodes LDE of the flexible film FPCB may be in contact with the pad portions PAD but may not be in contact with the first dummy pad portion DPAD1. The first dummy pad portion DPAD1 may have substantially the same structure as the pad portions PAD except that the first dummy pad portion DPAD1 is not electrically connected to the flexible film FPCB.

For example, the first dummy pad portions DPAD1 may be disposed on the first barrier insulating layer BIL1 or the second barrier insulating layer BIL2. As the first dummy pad portion DPAD1 disposed adjacent to the first pad portion PAD1, in FIG. 30, the first dummy pad portion DPAD1 disposed at the left side edge, which is one side of the first direction (e.g., the X-axis direction), may be disposed on the second barrier insulating layer BIL2 in the same manner as the even-numbered pad portion PAD2n (n being an integer). In the first dummy pad portion DPAD1 disposed at the left side edge, the main body portion may be disposed in the second contact hole CNT2 penetrating the first barrier insulating layer BIL1 and the second barrier insulating layer BIL2, and the extension portion may be directly disposed on the second barrier insulating layer BIL2. As the first dummy pad portion DPAD1 disposed adjacent to the second pad portion PAD2n, in FIG. 30, the first dummy pad portion DPAD1 disposed at the right side edge, which is the other side of the first direction (e.g., the X-axis direction), may be disposed on the first barrier insulating layer BIL1 in the same manner as the odd-numbered pad portion PAD2n-1 (n being an integer). In the first dummy pad portion DPAD1 disposed at the right side edge, the main body portion may be disposed in the first contact hole CNT1 penetrating the first barrier insulating layer BIL1, and the extension portion may be directly disposed on the first barrier insulating layer BIL1.

The first dummy pad portions DPAD1 may also be spaced from each other while being disposed on a different layer from the adjacent pad portions PAD, and the extension portions of the first dummy pad portions DPAD1 and the adjacent pad portions PAD may overlap each other in the thickness direction (e.g., the Z-axis direction). In the first dummy pad portion DPAD1 at the left side edge, the extension portion may overlap the extension portion of the first pad portion PAD1 in the thickness direction (e.g., the Z-axis direction), and in the first dummy pad portion DPAD1 at the right side edge, the extension portion may overlap the extension portion of the (2n)^{th} pad portion PAD2n in the thickness direction (e.g., the Z-axis direction). Although it is illustrated in the drawing that one first dummy pad portion DPAD1 is further disposed on each of the left side and right side of the pad portions PAD, the present disclosure is not limited thereto. In the display device 10_1, a larger number of the first dummy pad portions DPAD1 may be disposed as needed. When the width of the opening hole OP is greater than the area in which the pad portions PAD are disposed, the plurality of first dummy pad portions DPAD1 may be disposed on the left side and right side of the pad portions PAD, respectively.

In the process of etching by irradiating laser to form the opening hole OP of the first substrate SUB1, the adjacent pad portions PAD are disposed to overlap each other in the thickness direction (e.g., the Z-axis direction), and when the laser is irradiated, the second substrate SUB2 and the display layer DPL may be prevented from being damaged. The display device 10_1 may further include the first dummy pad portions DPAD1 in addition to the pad portions PAD, so that it is possible to prevent laser from passing through the first to third barrier insulating layers BIL1, BIL2, and BIL3 at the edge of the opening hole OP and reaching the second substrate SUB2. The display device 10_1 may further include the first dummy pad portions DPAD1 having substantially the same structure as the pad portions PAD without being electrically connected to the flexible film FPCB, so that the second substrate SUB2 and the display layer DPL may be more effectively prevented from being damaged in the laser process.

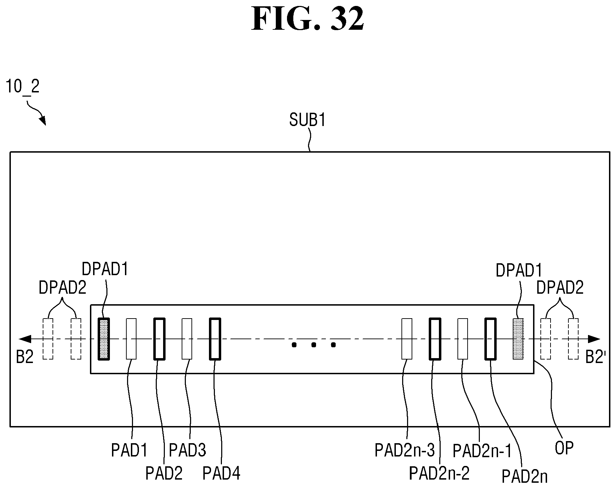

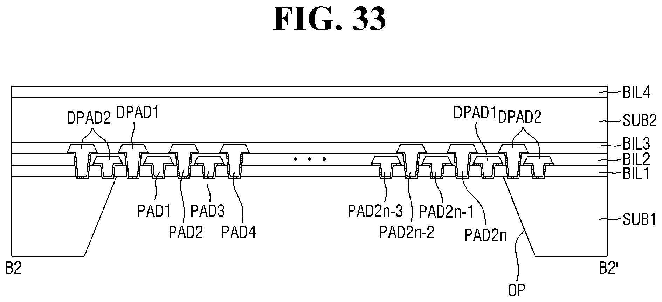

FIG. 32 is a plan view illustrating a disposition of pad portions disposed on a bottom surface of a display device. FIG. 33 is a cross-sectional view taken along the line B2-B2' of FIG. 32. FIG. 32 illustrates the disposition of the pad portions PAD1, PAD2, PAD3, PAD4, ..., PAD2n-1, and PAD2n and the first dummy pad portions DPAD1 disposed in the opening hole OP of the first substrate SUB1 at the edge of the long side of a display device 10_2 and second dummy pad portions DPAD2 that do not overlap the opening hole OP, and FIG. 33 is a cross-sectional view of FIG. 32 and illustrates a stacked structure from the first substrate SUB1 to the fourth barrier insulating layer BIL4.

Referring to FIGS. 32 and 33, the display device 10_2 may further include the first dummy pad portions DPAD1 in addition to the plurality of pad portions PAD. The display device 10_1 may include the plurality of pad portions PAD exposed through the opening hole OP formed in the bottom surface of the first substrate SUB1 and a plurality of first dummy pad portions DPAD1 adjacent to and spaced from the pad portion, among the pad portions PAD, disposed at an edge of the direction in which the pad portions PAD are arranged, for example, the first pad portion PAD1 or the (2n)^{th} pad portion PAD2n. The pad portions PAD may be disposed to be spaced from each other in the first direction (e.g., the X-axis direction), and may be electrically connected to the flexible film FPCB disposed on the bottom surface of the first substrate SUB1.

The plurality of pad portions PAD may include the odd-numbered pad portions PAD1, PAD3, ..., PAD2n-3, and PAD2n-1 (n being an integer) and the even-numbered pad portions PAD2, PAD4, ..., PAD2n-2, and PAD2n (n being an integer) alternately disposed along the first direction (X-axis direction). Because the description thereof is the same as the above description with reference to FIGS. 6 to 8, the detailed description thereof will be omitted.

The first dummy pad portions DPAD1 may be disposed to be spaced from any one of the pad portions PAD. The lower ends of the first dummy pad portions DPAD1 may also be exposed through the opening hole OP of the first substrate SUB1. However, the plurality of first dummy pad portions DPAD1 may have substantially the same shape as the pad portions PAD and may be arranged together with the pad portions PAD along the first direction (e.g., the X-axis direction), but may not be electrically connected to the flexible film FPCB disposed on the bottom surface of the first substrate SUB1. The lead electrodes LDE of the flexible film FPCB may be in contact with the pad portions PAD but may not be in contact with the first dummy pad portion DPAD1. The first dummy pad portion DPAD1 may have substantially the same structure as the pad portions PAD except that the first dummy pad portion DPAD1 is not electrically connected to the flexible film FPCB. Because the description of the first dummy pad portions DPAD1 is the same as the above description with reference to FIGS. 30 and 31, the detailed description thereof will be omitted.

The second dummy pad portions DPAD2 may be disposed to be spaced from any one of the first dummy pad portions DPAD1. Unlike the pad portions PAD and the first dummy pad portions DPAD1, the second dummy pad portions DPAD2 may be disposed so as not to overlap the opening hole OP of the first substrate SUB1, and may not be exposed by the opening hole OP. The plurality of second dummy pad portions DPAD2 may have substantially the same shape as the pad portions PAD and the first dummy pad portions DPAD1 and be arranged together with the pad portions PAD and the first dummy pad portions DPAD1 in the first direction (e.g., the X-axis direction), but may not be electrically connected to the flexible film FPCB disposed on the bottom surface of the first substrate SUB1. The second dummy pad portion DPAD2 may have substantially the same structure as the first dummy pad portions DPAD1 except that the second dummy pad portion DPAD2 is not exposed by the opening hole OP of the first substrate SUB1.

For example, the second dummy pad portions DPAD2 may be disposed on the first barrier insulating layer BIL1 or the second barrier insulating layer BIL2. The second dummy pad portions DPAD2 may be disposed on the first barrier insulating layer BIL1 or the second barrier insulating layer BIL2 according to the first dummy pad portion DPAD1 adjacently disposed or the disposition of another second dummy pad portion DPAD2. Some of the second dummy pad portions DPAD2 may be disposed on the first barrier insulating layer BIL1, and some others of the second dummy pad portions DPAD2 may be disposed on the second barrier insulating layer BIL2. The second dummy pad portions DPAD2 may also be spaced from each other while being disposed on a different layer from the adjacent first dummy pad portions DPAD1 and other adjacent second dummy pad portions DPAD2, and the extension portions overlap each other in the thickness direction (e.g., the Z-axis direction). A description thereof is substantially the same as that described above, and thus a detailed description thereof will be omitted.

The drawing illustrates that one first dummy pad portion DPAD1 is further disposed on each of the left side and right side of the pad portions PAD and two second dummy pad portions DPAD2 are spaced from the first dummy pad portions DPAD1 and disposed on each of the left side and right side of the pad portions PAD, but the present disclosure is not limited thereto. In the display device 10_2, a greater number of first dummy pad portions DPAD1 and second dummy pad portions DPAD2 may be disposed as needed. When the width of the opening hole OP is greater than the area in which the pad portions PAD are disposed, the plurality of first dummy pad portions DPAD1 may be disposed on the left side and right side of the pad portions PAD, respectively.

The display device 10_2 according to one or more embodiments may further include the first dummy pad portions DPAD1 and the second dummy pad portions DPAD2 having substantially the same structure as the pad portions PAD, without being electrically connected to the flexible film FPCB, so that the second substrate SUB2 and the display layer DPL may be more effectively prevented from being damaged in the laser process.

In concluding the detailed description, those skilled in the art will appreciate that many variations and modifications can be made to the embodiments without substantially departing from the scope of the invention as defined by the claims.

## Claims

1. A display device comprising:
a substrate (SUB1) comprising an opening (OP);
a first barrier insulating layer (BIL1) on the substrate;
a plurality of first pad portions (PAD1) on the first barrier insulating layer and in a first contact hole (CNT1) penetrating the first barrier insulating layer (BIL1);
a second barrier insulating layer (BIL2) on the first barrier insulating layer and the plurality of first pad portions (PAD1);
a plurality of second pad portions (PAD2) on the second barrier insulating layer and in a second contact hole (CNT2) penetrating the first barrier insulating layer (BIL1) and the second barrier insulating layer (BIL2);
a third barrier insulating layer (BIL3) on the second barrier insulating layer (BIL2) and the plurality of second pad portions (PAD2);
a display layer (DPL) on the third barrier insulating layer; and
a flexible film (FPCB) under the substrate, and inserted into the opening to be electrically connected to the plurality of first and second pad portions (PAD1, PAD2),
wherein each of the plurality of first pad portions and the plurality of second pad portions comprises a main body portion (PBP) inserted into the first contact hole or the second contact hole, and an extension portion (PWP) at both sides of the main body portion.

2. The display device of claim 1, wherein the extension portion of a first pad portion from among the plurality of first pad portions overlaps the extension portion of a second pad portion from among the plurality of second pad portions in a thickness direction of the substrate.

3. The display device of claim 1 or 2, wherein the plurality of first pad portions and the plurality of second pad portions are spaced from each other.

4. The display device of claim 3, wherein the extension portion of a first pad portion from among the plurality of first pad portions is spaced from the second contact hole and the main body portion of a second pad portion from among the plurality of second pad portions.

5. The display device of any one of the preceding claims, wherein a first pad portion from among the plurality of first pad portions and a second pad portion from among the plurality of second pad portions have lower ends of the main body portions spaced from each other, respectively, and
wherein a gap between the lower end of the first pad portion and the lower end of the second pad portion is greater than a width of the extension portion of each of the first pad portion and the second pad portion.

6. The display device of claim 5, wherein the width of the extension portion of each of the first pad portion and the second pad portion is between one half width and a full width of the gap between the lower end of the first pad portion and the lower end of the second pad portion.

7. The display device of claim 5 or 6, wherein the gap between the lower end of the first pad portion and the lower end of the second pad portion is about 16 µm, and
wherein the width of the extension portion of each of the first pad portion and the second pad portion is between 8 µm and 16 µm.

8. The display device of any one of the preceding claims, further comprising a plurality of first dummy pad portions (DPAD1) spaced from a first pad portion from among the plurality of first pad portions and a second pad portion from among the plurality of second pad portions, the plurality of first dummy pad portions being on the first barrier insulating layer or the second barrier insulating layer without being electrically connected to the flexible film, optionally wherein each of the plurality of first dummy pad portions overlaps the opening.

9. The display device of claim 8, further comprising a plurality of second dummy pad portions (DPAD2) spaced from the plurality of first dummy pad portions, the plurality of second dummy pad portions being on the first barrier insulating layer or the second barrier insulating layer without overlapping the opening.

10. The display device of any one of the preceding claims, further comprising:
a second substrate (SUB2) between the third barrier insulating layer and the display layer; and
a fourth barrier insulating layer (BIL4) between the second substrate and the display layer,
wherein the display layer (DPL) comprises:
a connection portion on the fourth barrier insulating layer and electrically connected to a first pad portion from among the plurality of first pad portions or a second pad portion from among the plurality of second pad portions;
a data line on the fourth barrier insulating layer and extending in a first direction; and
a high potential line on the fourth barrier insulating layer and extending in the first direction.

11. The display device of claim 10, wherein the first pad portion and the second pad portion are configured to supply a data voltage to a plurality of data lines through the connection portion, and
wherein the first pad portion and the second pad portion are configured to supply a high potential voltage to a plurality of high potential lines through the connection portion.

12. The display device of claim 10 or 11, wherein the display layer further comprises a buffer layer on the connection portion;
a thin film transistor comprising an active layer on the buffer layer; and
a connection electrode on the active layer,
wherein one end of the connection electrode is connected to the high potential line, and the other end of the connection electrode is connected to the thin film transistor.

13. The display device of claim 12, wherein the display layer further comprises a light emitting element layer on the connection electrode, and
wherein the light emitting element layer comprises:
a first electrode connected to the connection electrode;
a second electrode at the same layer as the first electrode; and
a light emitting element on the first electrode and the second electrode and electrically connected to the first electrode and the second electrode.

14. A method of manufacturing a display device, comprising:
preparing a first substrate;
forming a first barrier insulating layer on the first substrate and forming a plurality of first contact holes penetrating the first barrier insulating layer;
forming first pad portions on the first barrier insulating layer and partially inserted into the first contact hole;
forming a second barrier insulating layer on the first barrier insulating layer and the first pad portions, and forming a plurality of second contact holes penetrating the first barrier insulating layer and the second barrier insulating layer;
forming second pad portions on the second barrier insulating layer and partially inserted into the second contact hole;
forming a third barrier insulating layer disposed on the second barrier insulating layer and the second pad portions;
forming a display layer on the third barrier insulating layer;
etching the first substrate to form an opening to partially expose the first pad portions, the second pad portions, and the first barrier insulating layer; and
inserting a flexible film into the opening to be electrically connected to each of the first pad portions and the second pad portions.

15. The method of claim 14, wherein partially exposing the first pad portions, the second pad portions, and the first barrier insulating layer comprises irradiating the first substrate with a laser having a wavelength of 300 nm to 400 nm.

16. The method of claim 14 or 15, further comprising forming a second substrate on the third barrier insulating layer and forming a fourth barrier insulating layer on the second substrate.

17. A tiled display device comprising:
a plurality of display devices, each of the plurality of display devices comprising a display area having a plurality of pixels and a non-display area around the display area; and
a bonding member configured to bond the plurality of display devices,
wherein at least one of the plurality of display devices comprises a display device according to any one of claims 1 to 13.

## Patentansprüche

1. Anzeigevorrichtung, umfassend:
ein Substrat (SUB1), das eine Öffnung (OP) umfasst;
eine erste Barriereisolierschicht (BIL1) auf dem Substrat;
eine Vielzahl von ersten Pad-Abschnitten (PAD1) auf der ersten Barriereisolierschicht und in einem ersten Kontaktloch (CNT1), das die erste Barriereisolierschicht (BIL1) durchdringt;
eine zweite Barriereisolierschicht (BIL2) auf der ersten Barriereisolierschicht und der Vielzahl von ersten Pad-Abschnitten (PAD1);
eine Vielzahl von zweiten Pad-Abschnitten (PAD2) auf der zweiten Barriereisolierschicht und in einem zweiten Kontaktloch (CNT2), das die erste Barriereisolierschicht (BIL1) und die zweite Barriereisolierschicht (BIL2) durchdringt;
eine dritte Barriereisolierschicht (BIL3) auf der zweiten Barriereisolierschicht (BIL2) und der Vielzahl von zweiten Pad-Abschnitten (PAD2);
eine Anzeigeschicht (DPL) auf der dritten Barriereisolierschicht; und
eine flexible Folie (FPCB) unter dem Substrat, die in die Öffnung eingesetzt ist, um elektrisch mit der Vielzahl von ersten und zweiten Pad-Abschnitten (PAD1, PAD2) verbunden zu werden,
wobei jeder der Vielzahl von ersten Pad-Abschnitten und der Vielzahl von zweiten Pad-Abschnitten einen Hauptkörperabschnitt (PBP), der in das erste Kontaktloch oder das zweite Kontaktloch eingesetzt ist, und einen Erweiterungsabschnitt (PWP) an beiden Seiten des Hauptkörperabschnitts umfasst.

2. Anzeigevorrichtung nach Anspruch 1, wobei der Erweiterungsabschnitt eines ersten Pad-Abschnitts aus der Vielzahl von ersten Pad-Abschnitten den Erweiterungsabschnitt eines zweiten Pad-Abschnitts aus der Vielzahl von zweiten Pad-Abschnitten in einer Dickenrichtung des Substrats überlappt.

3. Anzeigevorrichtung nach Anspruch 1 oder 2, wobei die Vielzahl von ersten Pad-Abschnitten und die Vielzahl von zweiten Pad-Abschnitten voneinander beabstandet sind.

4. Anzeigevorrichtung nach Anspruch 3, wobei der Erweiterungsabschnitt eines ersten Pad-Abschnitts aus der Vielzahl von ersten Pad-Abschnitten von dem zweiten Kontaktloch und dem Hauptkörperabschnitt eines zweiten Pad-Abschnitts aus der Vielzahl von zweiten Pad-Abschnitten beabstandet ist.

5. Anzeigevorrichtung nach einem der vorhergehenden Ansprüche, wobei ein erster Pad-Abschnitt aus der Vielzahl von ersten Pad-Abschnitten und ein zweiter Pad-Abschnitt aus der Vielzahl von zweiten Pad-Abschnitten jeweils untere Enden der Hauptkörperabschnitte aufweisen, die voneinander beabstandet sind, und
wobei ein Spalt zwischen dem unteren Ende des ersten Pad-Abschnitts und dem unteren Ende des zweiten Pad-Abschnitts größer ist als eine Breite des Verlängerungsabschnitts jedes von dem ersten Pad-Abschnitt und dem zweiten Pad-Abschnitt.

6. Anzeigevorrichtung nach Anspruch 5, wobei die Breite des Erweiterungsabschnitts jedes von dem ersten Pad-Abschnitt und dem zweiten Pad-Abschnitt zwischen einer halben Breite und einer vollen Breite des Spalts zwischen dem unteren Ende des ersten Pad-Abschnitts und dem unteren Ende des zweiten Pad-Abschnitts beträgt.

7. Anzeigevorrichtung nach Anspruch 5 oder 6, wobei der Spalt zwischen dem unteren Ende des ersten Pad-Abschnitts und dem unteren Ende des zweiten Pad-Abschnitts etwa 16 µm beträgt und
wobei die Breite des Erweiterungsabschnitts jedes von dem ersten Pad-Abschnitt und dem zweiten Pad-Abschnitt zwischen 8 µm und 16 µm beträgt.

8. Anzeigevorrichtung nach einem der vorhergehenden Ansprüche, ferner umfassend eine Vielzahl von ersten Dummy-Pad-Abschnitten (DPAD1), die von einem ersten Pad-Abschnitt aus der Vielzahl von ersten Pad-Abschnitten und einem zweiten Pad-Abschnitt aus der Vielzahl von zweiten Pad-Abschnitten beabstandet sind, wobei sich die Vielzahl von ersten Dummy-Pad-Abschnitten auf der ersten Barriereisolierschicht oder der zweiten Barriereisolierschicht befindet, ohne elektrisch mit der flexiblen Folie verbunden zu sein, wobei optional jeder der Vielzahl von ersten Dummy-Pad-Abschnitten die Öffnung überlappt.

9. Anzeigevorrichtung nach Anspruch 8, ferner umfassend eine Vielzahl von zweiten Dummy-Pad-Abschnitten (DPAD2), die von der Vielzahl von ersten Dummy-Pad-Abschnitten beabstandet sind, wobei sich die Vielzahl von zweiten Dummy-Pad-Abschnitten auf der ersten Barriereisolierschicht oder der zweiten Barriereisolierschicht befindet, ohne die Öffnung zu überlappen.

10. Anzeigevorrichtung nach einem der vorhergehenden Ansprüche, ferner umfassend:
ein zweites Substrat (SUB2) zwischen der dritten Barriereisolierschicht und der Anzeigeschicht; und
eine vierte Barriereisolierschicht (BIL4) zwischen dem zweiten Substrat und der Anzeigeschicht,
wobei die Anzeigeschicht (DPL) Folgendes umfasst:
einen Verbindungsabschnitt auf der vierten Barriereisolierschicht, der elektrisch mit einem ersten Pad-Abschnitt aus der Vielzahl von ersten Pad-Abschnitten oder einem zweiten Pad-Abschnitt aus der Vielzahl von zweiten Pad-Abschnitten verbunden ist;
eine Datenleitung auf der vierten Barriereisolierschicht, die sich in einer ersten Richtung erstreckt; und
eine Hochpotentialleitung auf der vierten Barriereisolierschicht, die sich in der ersten Richtung erstreckt.

11. Anzeigevorrichtung nach Anspruch 10, wobei der erste Pad-Abschnitt und der zweite Pad-Abschnitt dazu konfiguriert sind, eine Vielzahl von Datenleitungen über den Verbindungsabschnitt mit einer Datenspannung zu versorgen, und
wobei der erste Pad-Abschnitt und der zweite Pad-Abschnitt dazu konfiguriert sind, eine Vielzahl von Hochpotentialleitungen über den Verbindungsabschnitt mit einer Hochpotentialspannung zu versorgen.

12. Anzeigevorrichtung nach Anspruch 10 oder 11, wobei die Anzeigeschicht ferner eine Pufferschicht auf dem Verbindungsabschnitt umfasst;
einen Dünnfilmtransistor, der eine aktive Schicht umfasst, auf der Pufferschicht; und
eine Verbindungselektrode auf der aktiven Schicht,
wobei ein Ende der Verbindungselektrode mit der Hochpotentialleitung verbunden ist und das andere Ende der Verbindungselektrode mit dem Dünnfilmtransistor verbunden ist.

13. Anzeigevorrichtung nach Anspruch 12, wobei die Anzeigeschicht ferner eine Schicht eines lichtemittierenden Elements auf der Verbindungselektrode umfasst, und
wobei die Lichtemissionselementschicht Folgendes umfasst:
eine erste Elektrode, die mit der Verbindungselektrode verbunden ist;
eine zweite Elektrode auf der gleichen Schicht wie die erste Elektrode; und
ein Lichtemissionselement an der ersten Elektrode und der zweiten Elektrode, das elektrisch mit der ersten Elektrode und der zweiten Elektrode verbunden ist.

14. Verfahren zum Herstellen einer Anzeigevorrichtung, umfassend:
Vorbereiten eines ersten Substrats;
Ausbilden einer ersten Barriereisolierschicht auf dem ersten Substrat und Ausbilden einer Vielzahl von ersten Kontaktlöchern, die die erste Barriereisolierschicht durchdringen;
Ausbilden erster Pad-Abschnitte auf der ersten Barriereisolierschicht, die teilweises in das erste Kontaktloch eingesetzt sind;
Ausbilden einer zweiten Barriereisolierschicht auf der ersten Barriereisolierschicht und den ersten Pad-Abschnitten und Ausbilden einer Vielzahl von zweiten Kontaktlöchern, die die erste Barriereisolierschicht und die zweite Barriereisolierschicht durchdringen;
Ausbilden zweiter Pad-Abschnitte auf der zweiten Barriereisolierschicht, die teilweise in das zweite Kontaktloch eingesetzt sind;
Ausbilden einer dritten Barriereisolierschicht, die auf der zweiten Barriereisolierschicht und den zweiten Pad-Abschnitten angeordnet ist;
Ausbilden einer Anzeigeschicht auf der dritten Barriereisolierschicht;
Ätzen des ersten Substrats, um eine Öffnung auszubilden, um die ersten Pad-Abschnitte, die zweiten Pad-Abschnitte und die erste Barriereisolierschicht teilweise freizulegen; und
Einsetzen einer flexiblen Folie in die Öffnung, so dass sie elektrisch mit jedem der ersten Pad-Abschnitte und der zweiten Pad-Abschnitte verbunden ist.

15. Verfahren nach Anspruch 14, wobei das teilweise Freilegen der ersten Pad-Abschnitte, der zweiten Pad-Abschnitte und der ersten Barriereisolierschicht Bestrahlen des ersten Substrats mit einem Laser mit einer Wellenlänge von 300 nm bis 400 nm umfasst.

16. Verfahren nach Anspruch 14 oder 15, ferner umfassend Ausbilden eines zweiten Substrats auf der dritten Barriereisolierschicht und Ausbilden einer vierten Barriereisolierschicht auf dem zweiten Substrat.

17. Gekachelte Anzeigevorrichtung, umfassend:
eine Vielzahl von Anzeigevorrichtungen, wobei jede der Vielzahl von Anzeigevorrichtungen einen Anzeigebereich mit einer Vielzahl von Pixeln und einen Nicht-Anzeigebereich um den Anzeigebereich herum umfasst; und
ein Bindeelement, das dazu konfiguriert ist, die Vielzahl von Anzeigevorrichtungen aneinander zu binden,
wobei mindestens eine der Vielzahl von Anzeigevorrichtungen eine Anzeigevorrichtung nach einem der Ansprüche 1 bis 13 umfasst.

## Revendications

1. Dispositif d'affichage comprenant :
un substrat (SUB1) comprenant une ouverture (OP) ;
une première couche isolante barrière (BIL1) sur le substrat ;
une pluralité de premières parties de pastilles (PAD1) sur la première couche isolante barrière et dans un premier trou de contact (CNT1) pénétrant dans la première couche isolante barrière (BIL1) ;
une deuxième couche isolante barrière (BIL2) sur la première couche isolante barrière et la pluralité de premières parties de pastilles (PAD1) ;
une pluralité de secondes parties de pastilles (PAD2) sur la deuxième couche isolante barrière et dans un second trou de contact (CNT2) pénétrant dans la première couche isolante barrière (BIL1) et la deuxième couche isolante barrière (BIL2) ;
une troisième couche isolante barrière (BIL3) sur la deuxième couche isolante barrière (BIL2) et la pluralité de secondes parties de pastilles (PAD2) ;
une couche d'affichage (DPL) sur la troisième couche isolante barrière ; et
un film flexible (FPCB) sous le substrat, et inséré dans l'ouverture pour être électriquement connecté à la pluralité de premières et secondes parties de pastilles (PAD1, PAD2),
dans lequel chacune de la pluralité de premières parties de pastilles et de la pluralité de secondes parties de pastilles comprend une partie de corps principal (PBP) insérée dans le premier trou de contact ou le second trou de contact, et une partie d'extension (PWP) des deux côtés de la partie de corps principal.

2. Dispositif d'affichage selon la revendication 1, dans lequel la partie d'extension d'une première partie de pastille parmi la pluralité de premières parties de pastilles chevauche la partie d'extension d'une seconde partie de pastille parmi la pluralité de secondes parties de pastilles dans le sens de l'épaisseur du substrat.

3. Dispositif d'affichage selon la revendication 1 ou 2, dans lequel la pluralité de premières parties de pastilles et la pluralité de secondes parties de pastilles sont espacées les unes des autres.

4. Dispositif d'affichage selon la revendication 3, dans lequel la partie d'extension d'une première partie de pastille parmi la pluralité de premières parties de pastilles est espacée du second trou de contact et de la partie de corps principal d'une seconde partie de pastille parmi la pluralité de secondes parties de pastilles.

5. Dispositif d'affichage selon l'une quelconque des revendications précédentes, dans lequel une première partie de pastille parmi la pluralité de premières parties de pastilles et une seconde partie de pastille parmi la pluralité de secondes parties de pastilles ont des extrémités inférieures des parties de corps principal espacées les unes des autres, respectivement, et
dans lequel un espace entre l'extrémité inférieure de la première partie de pastille et l'extrémité inférieure de la seconde partie de pastille est supérieur à une largeur de la partie d'extension de chacune de la première partie de pastille et de la seconde partie de pastille.

6. Dispositif d'affichage selon la revendication 5, dans lequel la largeur de la partie d'extension de chacune de la première partie de pastille et de la seconde partie de pastille se situe entre une demi-largeur et une largeur totale de l'espace entre l'extrémité inférieure de la première partie de pastille et l'extrémité inférieure de la seconde partie de pastille.

7. Dispositif d'affichage selon la revendication 5 ou 6, dans lequel l'espace entre l'extrémité inférieure de la première partie de pastille et l'extrémité inférieure de la seconde partie de pastille est d'environ 16 µm, et
dans lequel la largeur de la partie d'extension de chacune de la première partie de pastille et de la seconde partie de pastille se situe entre 8 µm et 16 µm.

8. Dispositif d'affichage selon l'une quelconque des revendications précédentes, comprenant en outre une pluralité de premières parties de pastilles factices (DPAD1) espacées d'une première partie de pastille parmi la pluralité de premières parties de pastilles et d'une seconde partie de pastille parmi la pluralité de secondes parties de pastilles, la pluralité de premières parties de pastilles factices étant sur la première couche isolante barrière ou la deuxième couche isolante barrière sans être électriquement connectées au film flexible, éventuellement dans lequel chacune de la pluralité de premières parties de pastilles factices chevauche l'ouverture.

9. Dispositif d'affichage selon la revendication 8, comprenant en outre une pluralité de secondes parties de pastilles factices (DPAD2) espacées de la pluralité de premières parties de pastilles factices, la pluralité de secondes parties de pastilles factices étant sur la première couche isolante barrière ou la deuxième couche isolante barrière sans chevaucher l'ouverture.

10. Dispositif d'affichage selon l'une quelconque des revendications précédentes, comprenant en outre :
un second substrat (SUB2) entre la troisième couche isolante barrière et la couche d'affichage ; et
une quatrième couche isolante barrière (BIL4) entre le second substrat et la couche d'affichage,
dans lequel la couche d'affichage (DPL) comprend :
une partie de connexion sur la quatrième couche isolante barrière et électriquement connectée à une première partie de pastille parmi la pluralité de premières parties de pastilles ou une seconde partie de pastille parmi la pluralité de secondes parties de pastilles ;
une ligne de données sur la quatrième couche isolante barrière et s'étendant dans une première direction ; et
une ligne à haut potentiel sur la quatrième couche isolante barrière et s'étendant dans la première direction.

11. Dispositif d'affichage selon la revendication 10, dans lequel la première partie de pastille et la seconde partie de pastille sont configurées pour fournir une tension de données à une pluralité de lignes de données à travers la partie de connexion, et
dans lequel la première partie de pastille et la seconde partie de pastille sont configurées pour fournir une tension à haut potentiel à une pluralité de lignes à haut potentiel à travers la partie de connexion.

12. Dispositif d'affichage selon la revendication 10 ou 11, dans lequel la couche d'affichage comprend en outre une couche tampon sur la partie de connexion ;
un transistor à couches minces comprenant une couche active sur la couche tampon ; et
une électrode de connexion sur la couche active,
dans lequel une extrémité de l'électrode de connexion est connectée à la ligne à haut potentiel, et l'autre extrémité de l'électrode de connexion est connectée au transistor à couches minces.

13. Dispositif d'affichage selon la revendication 12, dans lequel la couche d'affichage comprend en outre une couche d'élément électroluminescent sur l'électrode de connexion, et
dans lequel la couche d'élément électroluminescent comprend :
une première électrode connectée à l'électrode de connexion ;
une seconde électrode au niveau de la même couche que la première électrode ; et
un élément électroluminescent sur la première électrode et la seconde électrode et électriquement connecté à la première électrode et à la seconde électrode.

14. Procédé de fabrication d'un dispositif d'affichage, comprenant :
la préparation d'un premier substrat ;
la formation d'une première couche isolante barrière sur le premier substrat et la formation d'une pluralité de premiers trous de contact pénétrant dans la première couche isolante barrière ;
la formation de premières parties de pastilles sur la première couche isolante barrière et partiellement insérées dans le premier trou de contact ;
la formation d'une deuxième couche isolante barrière sur la première couche isolante barrière et les premières parties de pastilles, et la formation d'une pluralité de seconds trous de contact pénétrant dans la première couche isolante barrière et la deuxième couche isolante barrière ;
la formation de secondes parties de pastilles sur la deuxième couche isolante barrière et partiellement insérées dans le second trou de contact ;
la formation d'une troisième couche isolante barrière disposée sur la deuxième couche isolante barrière et les secondes parties de pastilles ;
la formation d'une couche d'affichage sur la troisième couche isolante barrière ;
la gravure du premier substrat pour former une ouverture pour exposer partiellement les premières parties de pastilles, les secondes parties de pastilles et la première couche isolante barrière ; et
l'insertion d'un film flexible dans l'ouverture pour être électriquement connecté à chacune des premières parties de pastilles et des secondes parties de pastilles.

15. Procédé selon la revendication 14, dans lequel l'exposition partielle des premières parties de pastilles, des secondes parties de pastilles et de la première couche isolante barrière comprend l'irradiation du premier substrat avec un laser ayant une longueur d'onde de 300 nm à 400 nm.

16. Procédé selon la revendication 14 ou 15, comprenant en outre la formation d'un second substrat sur la troisième couche isolante barrière et la formation d'une quatrième couche isolante barrière sur le second substrat.

17. Dispositif d'affichage en mosaïque comprenant :
une pluralité de dispositifs d'affichage, chacun de la pluralité de dispositifs d'affichage comprenant une zone d'affichage comportant une pluralité de pixels et une zone de non-affichage autour de la zone d'affichage ; et
un élément de liaison conçu pour relier la pluralité de dispositifs d'affichage,
dans lequel au moins un de la pluralité de dispositifs d'affichage comprend un dispositif d'affichage selon l'une quelconque des revendications 1 à 13.
